(19) Europäisches Patentamt
European Patent Office
Office européen des brevets

(11) Publication number: 0 164 248 B1

# (12) EUROPEAN PATENT SPECIFICATION

(45) Date of publication of patent specification: 09.10.91 (51) Int. Cl.[5]: G03F 7/022, G03F 7/38

(21) Application number: 85303807.3

(22) Date of filing: 30.05.85

## (54) Photosensitive coating compositions, thermally stable coatings prepared from them, and the use of such coatings in forming thermally stable polymer images.

(30) Priority: 01.06.84 US 616518

(43) Date of publication of application:
11.12.85 Bulletin 85/50

(45) Publication of the grant of the patent:
09.10.91 Bulletin 91/41

(84) Designated Contracting States:
AT BE CH DE FR GB IT LI LU NL SE

(56) References cited:
EP-A- 0 131 238
DE-A- 1 447 919
DE-A- 2 322 230
DE-B- 1 097 273
US-A- 4 121 936
US-A- 4 431 725
DE-A- 867 119
DE-A- 1 522 527
DE-A- 2 855 723
FR-A- 1 555 473
US-A- 4 246 374

PATENTS ABSTRACTS OF JAPAN, vol. 5, no. 77 (P-62)[749], 21st May 1981; & JP-A-56 25 730 (KANTOU KAGAKU K.K.) 12-03-1981

ANGEWANDTE CHEMIE, INTERNATIONAL EDITION ENGLISH, vol. 15, no. 5, May 1976, pages 270-281, Verlag Chemie, Weinheim, DE; A.I. MEYERS et al: "The synthetic utility of 2-Oxazolines"

CHEMICAL ABSTRACTS, vol. 87, no. 20, 14th November 1977, page 70, abstract no. 153497p, Columbus, Ohio, US; W.D. EMMONS et al.: "High performance isocyanate-oxazolidine coatings", & J. COAT. TECHNOL 1977, 49(631), 65-73

RESEARCH DISCLOSURE, no. 242, June 1984, page 240, disclosure no. 24205, Havant, Hampshire, GB: "An image reversible positive photoresist with chemically induced high temperature rheological stability"

(73) Proprietor: ROHM AND HAAS COMPANY
Independence Mall West
Philadelphia Pennsylvania 19105(US)

(72) Inventor: Feely, Wayne Edmund
1172 Lindsay Lane
Rydal Pennsylvania 19046(US)

(74) Representative: Angell, David Whilton et al
ROHM AND HAAS (UK) LTD. European Operations Patent Department Lennig House 2
Mason's Avenue
Croydon CR9 3NB(GB)

EP 0 164 248 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention is concerned with photosensitive coating compositions, thermally stable coatings prepared from them, and the use of such coatings in forming thermally stable polymer images. More particularly, the invention is concerned with dual acting, aqueous developable, crosslinkable, polymer coatings formed from photosensitive coating compositions containing acid hardening resin system and photoacid generator dissolved in suitable solvent, and to processes for forming high quality, thermally stable, crosslinked, positive and negative polymer images on substrate surfaces using such photosensitive coating compositions.

Although it is well known to prepare surface coatings from photosensitive polymer compositions and from acid hardening resins, workers have been unable to develop reliable, dual acting, photosensitive coatings that are aqueous base developable and capable of yielding high quality images that are stable to temperatures above about 150 °c.

Acid hardening resins, such as aminoplasts and phenoplasts, are polymers that cure or harden by the catalytic action of acids on heating. Photosensitive polymer compositions that are used as coatings typically contain a film forming polymer, such as a thermoplastic phenol-formaldehyde novolak resin, and a photosensitive compound, referred to herein as a photoacid generator. The photoacid generator acts either to increase or decrease the solubility of the coating in a developer solution upon exposure to actinic radiation. A photoresist is a photosensitive coating used to transfer images, or relief patterns, such as an electronic circuit delineated on a photomask having areas that are opaque to actinic radiation and other areas that are transparent to the radiation, onto a substrate surface such as the surface of a silicon wafer, printed circuit board or lithographic printing plate. The image is formed by the action of actinic radiation on the photosensitive coating or resist followed by the selective removal or development of the soluble or solubilized portions of the photoresist. Accordingly, the transferred image corresponds to either the opaque or transparent areas delineated by the photomask, and the type of image thus formed is a function of the photochemical reaction that the photoresist undergoes upon exposure to the actinic radiation. In the case of a negative resist, the exposed areas of the coating undergo a reaction that renders these areas relatively less soluble than the unexposed areas in a developer solution, and the resulting image pattern formed on the substrate surface corresponds to the transparent areas delineated by the photomask. In the case of a positive acting resist, the exposed coating areas undergo a photochemical reaction that renders these areas capable of being selectively removed by, or more soluble than the unexposed areas in, a developer solution, thus yielding an image or relief pattern corresponding to the opaque areas of the photomask.

In certain applications, it may be more desirable to utilize a photoresist that operates in the positive or in the negative manner depending on the image resolution that can be achieved or is desired, the cost of the resist and other processing requirements. Ideally, it would be desirable to have a photoresist or photosensitive coating that is capable of being developed using an aqueous developer rather than an organic solvent such that swelling of the image or its dissolution is prevented. Swelling or dissolution of the resist or extraction of the resist components by the developer decreases the quality and resolution of the resulting image. Aqueous developers also reduce flammability, health and environmental problems that could result from using an organic solvent developer. Furthermore, it is desirable for such an aqueous developable resist to be capable of acting either as a positive or as a negative resist. Still further, it would be highly beneficial if such a resist were capable of yielding the maximum image resolution achievable without relying on a relatively narrow difference in the solubility of the exposed and unexposed film areas. If the developer acted solely on the portion of the resist film to be removed development time would be eliminated as a critical step in the process of its use.

Furthermore, it would be highly beneficial if the photoresist or photosensitive coating were formed as a single package of ingredients having long term ambient temperature stability. This would ensure reproducible results independent of when the system is formulated or used. Most importantly, if the images formed from such a system were to possess a high degree of thermal stability, such that the images do not flow or otherwise deteriorate when subjected to high temperatures during subsequent processing, such as etching, in addition to chemical and electrical resistance, the system would be a major improvement over conventional systems.

US 3,201,239 discloses the combination of a thermoplastic, phenol-formaldehyde novolak resin with a naphthquinone diazide or naphthoquinone diazide sulfonic acid ester photosensitizer as a positive acting coating. US 3,692,560 discloses using an acid hardening resin such as urea and melamine resins with photoacid generating halogen substituted benzophenones. These photoacid generators when exposed to ultraviolet light produce strongly acidic hydrogen halides that catalyze the formation of negative, organic solvent developable, images. The use of halogen acids in particular, and halogen containing compounds in

general, as well as organic solvent developers are unsatisfactory for use in microelectronic circuit manufacturing processes because the halogen compounds, as well as other strong acids typically used to harden such resins, tend to interfere with electrical dopants used in preparing the circuitry. Organic solvent developers are undesirable for environmental, health and flammability reasons. US 3,697,274 discloses the preparation of printing plates using a negative resist system containing an acid curable resin by which exposed areas are heated and the unexposed areas are developed using an organic solvent developer. US 3,402,044 discloses a photosensitive coating for printing plates containing a naphthoquinone diazide sulfonic acid sensitizer and an alkali-soluble phenol or cresol-formaldehyde novolak resin capable of being developed with an aqueous base solution. This positive resist system is thermoplastic and does not further polymerize on baking. The images formed are thermally unstable at temperatures in the range of about 100 to about 150°C. US 3,666,473 is directed to an aqueous base developable thermoplastic positive resist utilizing a mixture of a novolak resin and a resol resin with conventional photosensitizer. The mixture of these resins, having different aqueous base solubilities, is taught to increase the photospeed of the resist. However, the patent is silent concerning the ability of this system to form thermally stable, aqueous developable, positive and negative acting images. US 3,759,711 describes an aqueous base developable photosensitive coating for graphic arts application employing a phenol-formaldehyde novolak or resol resin with a polymeric photosensitive compound in which quinone diazide groups are linked to the polymer backbone through nitrogen atoms. This patent expressly warns against heating the resins to cause them to harden in a non-imagewise manner.

US 3,890,152 discloses a dual acting resist utilizing a positive acting o-quinone diazide photosensitizer and a negative diazonium salt in combination with a variety of resins. Positive images are developed using an aqueous base and negative images are developed using an aqueous acid. Reexposure of the positive image after development is taught to harden the image. US 4,007,047 is also directed to a dual acting resist in which, after the resist is exposed to form an aqueous base soluble positive image, the exposed areas are treated with a solution containing hydrogen ions to decrease the aqueous base solubility of the exposed areas. The entire resist can then be reexposed forming an aqueous base developable negative image. The resist is formed from an alkali-soluble phenol-formaldehyde resin and a naphthoquinone diazide sulfonic acid ester sensitizer. This patent also discloses a method for forming a negative image starting with a positive resist containing a thermoplastic, phenol-formaldehyde novolak resin, a naphthoquinone sensitizer, and 1-hydroxyethyl-2-alkyl imidazoline. Exposure and development leads to a positive image while alternatively, heating the exposed resist renders the exposed areas insoluble in an aqueous base. Reexposure of the entire resist followed by aqueous base development leads to a negative image. While the patent refers to the heated resist as being crosslinked, the patent defines crosslinked by referring to the fact that the heated exposed areas are insoluble in aqueous base. This incorrect terminology should not be confused or misinterpreted as teaching that the system leads to a truly crosslinked thermoset image which will not flow at temperatures in excess of about 200°C and is insoluble in organic solvents. As demonstrated by comparative Example 77 presented herein, the images of US patent 4,104,070 melt at about 120 to about 125°C and readily dissolve in organic solvents.

US 3,827,908 discloses that imidazolines improve the adhesion of positive resists onto silicon dioxide surfaces. US 4,104,070 also discloses that imidazoline contributes to the excellent adhesion of the resist to the substrate when etching is subsequently required. It has been found, (S. A. MacDonald et al, Kodak Microelectronics Seminar, 1982 pages 114 to 117) that the hydroxyethyl imidazoline, known as Monazoline-C, causes decarboxylation of indenecarboxylic acids formed upon rearrangement of the exposed o-quinone diazide on heating. This decarboxylation mechanism renders the initially aqueous base soluble resist insoluble, and, when the resist is reexposed, an indenecarboxylic acid is generated in the initially unexposed areas rendering these areas aqueous base soluble. On development, this leads to a negative image. Other substances that cause indenecarboxylic acids to decarboxylate and render the exposed resist insoluble in an aqueous base include imidazole and triethanolamine. This decarboxylation mechanism is also described in: Introduction to Microlithography, L. F. Thompson, C. G. Willson, and M. J. Bowden, ACS Symposium Series No. 219, ACS, pages 117-121 (1983).

US 4,115,128 discloses a positive resist containing an o-naphthoquinone diazide sensitizer, an alkali soluble phenolic resin, and 1 to 5 weight percent of an organic acid cyclic anhydride. The cyclic anhydride is taught to increase the photospeed of the resist. US 4,196,003 is directed to a dual acting photosensitive copying layer containing an o-quinone diazide, a thermoplastic phenol-formaldehyde or cresol-formaldehyde resin, and a secondary or tertiary amine. Heat treatment of the exposed resist is taught to accelerate the aqueous base insolubilization of the exposed areas as in US 4,104,070. US 4,196,003 also discloses tertiary cyclic amines, such as hexamethylenetetramine, as being suitable tertiary amines. In addition to causing the exposed resist to become insoluble in aqueous base upon heating, the tertiary cyclic amine has also been

found to crosslink the resin. However, hexamethylenetetramine has also been found to be unstable at ambient temperatures and, therefore, unsuitable for use in a practical dual acting thermally stable resist. US 4,356,254 is also directed to a dual acting resist in which a basic carbonium ion dye acts to insolubilize the exposed areas of the resist. US 4,356,255 discloses a dual acting resist using a quinone diazide sensitizer and a quinone or aromatic ketone. As in the other prior art dual acting systems, the exposed areas are rendered insoluble in an aqueous base. GB Patent 1,494,640 is also directed to a dual acting resist relying on a similar mechanism in which a compound containing a hydroxy group, such as a hydroxy-containing novolak, and additional compounds such as Bisphenol-A, pyrogallol and triethanolamines are used.

Other references disclosing thermally stable positive resists, based on completely different resin systems and chemical mechanisms from the present invention, include US 4,339,521; 4,395,482; 4,404,357; 4,410,612; 4,414,312; and 4,424,315.

US 4,431,725 discloses a negative working process for forming images, which comprises utilising a light sensitive material comprising an o-quinonediazide compound and a compound which reacts directly or catalytically with the photochemical reaction products of the o-quinonediazide compound.

DE-A-1,522,527 discloses a method for the manufacture of sensitive photocopying resists, in which there is added, to the per se known light-sensitive substance naphthoquinone - (1,2) - diazide - (2) - sulfonic add - (5) - chloride, a resin which has free amino groups, the resin being added as a stabilising substance.

Despite the numerous inventions in the field of photosensitive coatings, presently there are no aqueous developable, dual acting, thermally stable, photosensitive coatings that are capable of forming highly thermally stable, high resolution images on surfaces.

The present invention enables the use of aqueous developable, dual acting, crosslinkable, photosensitive coatings to form thermally stable, high quality polymer images of micron to submicron resolution on surfaces, thermally stable planarizing images on electronic devices, and imageable protective coatings for microelectronic devices.

According to the present invention there is provided a process for forming a thermally stable, positive or negative image on a substrate surface characterized in that it comprises:

a) preparing a photosensitive coating composition comprising aminoplast resin and reactive hydrogen containing compound, or phenoplast resin and latent formaldehyde generating compound, as acid hardening resin system, and naphthoquinone diazide sulfonic acid ester or polymer derived therefrom as photoacid generator, dissolved in suitable solvent;

b) depositing the coating composition on a substrate surface;

c) drying the coated substrate surface to form a touch tack free photosensitive film on the substrate surface;

d) creating an acidic latent image in the film by exposing the film to a source of actinic radiation; and

e) either

i) forming a negative image on the substrate surface by heating the acidic latent image in the film to 70 to 120°C, re-exposing the film to a source of actinic radiation, and developing the re-exposed film with an aqueous solution; or

ii) forming a positive image on the substrate surface by removing the acidic latent image in the film with an aqueous solution and leaving a remaining film on the substrate surface, re-exposing the remaining film to a source of actinic radiation to form a second acidic latent image in the remaining film, and heating the second acidic latent image in the remaining film to 70 to 120°C.

The coating composition and/or coating according to the present invention may, for example, comprise 20 to 30 weight percent of photoacid generator and 80 to 75 weight percent of acid hardening resin system, based on the total solids content of the coating composition or coating.

The thermal stability of the polymer images produced by the process according to the invention refers to their ability to withstand heating to at least 200°C, and preferably 300°C to about 500°C, without significant loss of image resolution or quality. This high thermal stability renders the images particularly useful in the formation and protection of electronic devices.

To avoid the undesirable properties mentioned below, the photoacid generator used in the invention should be thermally stable when the unexposed coating or film containing it is dried at temperatures from about 90 to 100°C for about 30 minutes. Thermal stability in the context of the coating composition and unexposed film refers to the fact that the unexposed photoacid generator should not generate acid at these drying temperatures. Generation of an acid results in a loss of resolution of resulting positive images or premature acid hardening of the film. Similarly, in the case of negative image formation, the unexposed areas of the coating or film containing inactive or unexposed photoacid generator should also be stable and not generate acid when a second heating or baking step is employed at temperatures ranging from about 90°C to about 100°C for 15 to 30 minutes. This second baking step should also not adversely affect the

unexposed areas of the film.

Furthermore, it is highly desirable for the photosensitive coating composition to remain stable, after formulation and prior to use, for periods up to about one year at ambient temperatures, thus, ensuring uniform processing capability for the coating composition.

Thermally stable images, produced according to the process of the invention, can provide a number of significant advantages over conventional surface relief patterns or images, for example, they can be positive or negative images and can have high resolution.

The following features when used separately or in combination give preferred embodiments of the present invention:

(i) the acid hardening resin system is soluble in a non-reacting solvent or solvent mixture;

(ii) the photoacid generator and the acid hardening resin system form a homogeneous solution in the solvent system, when employed in specified concentrations;

(iii) the photoacid generator and the acid hardening resin system are capable of forming a homogeneous, uniform, non-tacky, adherent film free of cracks, crazing and other defects on a substrate surface;

(iv) the photoacid generator is a neutral compound, or mixture of compounds, which form neither an acid nor a base in water;

(v) the photoacid generator is predominantly hydrophobic and insoluble in water and aqueous base solutions when unexposed to actinic radiation and is stable at ambient temperatures;

(vi) when the coating or film is exposed to actinic radiation, the exposed areas should be at least two hundred times more soluble in an aqueous base developer than the unexposed areas in order to achieve rapid development and high quality image resolution;

(vii) the acid generated by the photoacid generator in the exposed portions of the coating or film does not cause any chemical changes to occur in a substrate to which the coating or film is adhered, in particular, in the case of electronic substrates, the acid does not cause chemical attack of any aluminum circuit components or introduce ions or atoms that interfere with the normal electronic functioning of the substrate and which can therefore cause the contamination of any silicon or germanium semiconductors present;

(viii) the photoacid does not cause acid hardening of the photosensitive coating at ambient temperatures; any occurrence of acid hardening of the coating at ambient temperatures would adversely affect the development of a positive image and poor image quality and resolution would result;

(ix) the photochemically generated acid is capable of causing an acid-hardening crosslinking reaction to occur when the exposed coating or film is subsequently heated to a temperature of 70°C to 120°C, preferably 90°C to 100°C, for 15 to 30 minutes; and/or

(x) the photochemically generated acid is capable of functioning either as a coating or film solubilizer or as a catalyst for the acid hardening crosslinking reaction at elevated temperatures.

We have found negative images, formed according to the present invention, to have significant process advantages over conventional positive images formed from novolak-naphthoquinone diazide systems, in addition to improved thermal stability. For example, the negative images have been found to be capable of high resolution. The process advantage is caused by the insolubility of the crosslinked negative image in an aqueous base developer. Since the differential solubility between the crosslinked image and the acid latent image contained in the exposed but uncrosslinked film areas is extremely high, and can approach an infinite differential, the time needed to develop the negative image formed according to the present invention is not a critical factor in the process.

The photosensitive coating composition used in the invention may, for example, contain from 3 to 50 weight percent of aminoplast or phenoplast resin, from 40 to 90 weight percent of reactive hydrogen containing compound, and from 2 to 30 weight percent of photoacid generator, the percentages being based on the total weight of solids in the composition.

The acid hardening resin system used in the present invention contains a polymer that will crosslink in the presence of an acid catalyst and heat. The acid hardening resin systems may, for example, be prepared from a wide variety of aminoplasts or phenoplasts in combination with one or more compound and/or low molecular weight polymer containing a plurality of hydroxyl, carboxyl, amide or imide groups.

Aminoplast resins suitable for use in the acid hardening resin system include urea-formaldehyde, melamine-formaldehyde, benzoguanamine-formaldehyde and glycoluril-formaldehyde resins and combinations thereof. Polymeric aminoplasts are also suitable for use in the acid hardening resin system and may, for example, be prepared by the reaction of acrylamide or methacrylamide copolymers with formaldehyde in an alcohol-containing solution, or by the copolymerization of N-alkoxymethyl acrylamide or methacrylamide with other suitable monomers. Examples of suitable aminoplasts include the melamine resins manufactured by American Cyanamid Company such as Cymel 300, 301, 303, 350, 370, 380, 1116

and 1130; benzoguanamine resins such as Cymel 1123 and 1125; glycoluril resin Cymel 1170; and urea-based resins Beetle 60, 65 and 80. A large number of similar aminoplasts are presently commercially available from various suppliers.

As indicated above, the aminoplasts are used in combination with one or more reactive hydrogen-containing compound in the acid hardening resin system. These reactive hydrogen-containing compounds include: novolak resins; polyvinyl phenols (PVP); polyglutarimides (PG); acrylic acid and methacrylic acid copolymers; alkali-soluble polyacrylamides and methacrylamide copolymers; copolymers containing 2-hydroxyethyl acrylate and methacrylate; and polyvinyl alcohols such as those prepared from partially hydrolyzed polyvinyl acetates; alkali-soluble styrene-allyl alcohol copolymers. Novolak resins containing hydroxyl groups and sites for the electrophilic substitution of aromatic rings at positions ortho or para relative to the hydroxyl group are preferred. Novolak resins that are useful in conjunction with aminoplasts in the acid hardening resin system may, for example, be alkali-soluble film forming phenolic resins having a molecular weight (weight average) ranging of about 300 to about 100,000, preferably about 1000 to 20,000. Such novolak resins may, for example, be prepared by the condensation reaction of a phenol, a naphthol or a substituted phenol, such as cresol, xylenol, ethylphenol, butylphenol, isopropyl, methoxyphenol, chlorophenol, resorcinol or hydroquinone, with, for example, formaldehyde, acetaldehyde, furfural acrolein or the like. Blends of suitable novolak resins may, for example, be used in order to adjust the dissolution rate of the exposed coating in aqueous base solutions and/or for adjusting the viscosity, hardness and/or other physical properties of the coating. Novolak resins which may, for example, be used in the present invention are disclosed in US 3,148,983; 4,404,357; 4,115,128; 4,377,631; 4,423,138; and 4,424,315.

In one embodiment of the invention the reactive hydrogen containing compound comprises alkali soluble resin, the alkali soluble resin being one or more of phenolic novolaks, cresolic novolaks, polyglutarimides, polyvinylphenols, and (meth)acrylic acid-styrene copolymers formed from at least 15 weight percent (meth)acrylic acid.

Polyglutarimides having a weight average molecular weight of about 1000 to about 100,000, which are soluble in aqueous base and contain at least 40 weight percent of the nitrogen atoms in the NH or ammonia form, e.g., polyglutarimides prepared according to US 4,246,374 may, for example, be used in conjunction with aminoplasts in the acid hardening resin system. Polyglutarimides are useful for preparing coatings that can be exposed to deep ultraviolet (UV) actinic radiation of the order of 254 nanometers. When polyglutarimides are used in conjunction with aminoplast resins, the aminoplast is conveniently present at a concentration of about 20 to about 80 percent by weight based on the weight of the polyglutarimide. Aminoplast resins, such as Cymel 303, in combination with polyglutarimides having a molecular weight of about 71,000 and containing 58 mole percent ammonia imide (N-H) and 42 mole percent methylimide ($NCH_3$) and a naphthoquinone diazide photoacid generator are particularly suitable for forming dual acting, aqueous developable photosensitive coatings that can be exposed to either deep UV (254 nanometers) or near UV (365 nanometers) actinic radiation yielding thermally stable images.

Alkali soluble polyvinylphenols having a weight average molecular weight of about 2000 to about 100,000 can also be employed with aminoplasts to form useful acid hardening resin systems suitable for use in the dual acting, photosensitive polymer coating compositions and coatings. These coating compositions and coatings are capable of yielding highly thermally stable images which can withstand heating for about 30 minutes at a temperature of about 400 to about 500 °C.

Alkali-soluble (meth)acrylic acid-styrene copolymer containing at least 15 weight percent, preferably 30 weight percent, of (meth)acrylic acid units and having a weight average molecular weight of about 12,000 can also be used in combination with aminoplasts to form an acid hardening resin system useful in the practice of the invention for preparing positive and negative thermally stable images on surfaces, for example, silicon dioxide wafers.

The coating compositions and/or coatings may, for example, comprise 3 to 50 parts by weight of aminoplast resin, 90 to 40 parts by weight of reactive hydrogen containing compound and 2 to 30 parts by weight of photoacid generator.

Acid hardening resin systems useful in the photosensitive coatings can also be prepared from phenoplasts by combining one or more compound that is a latent source of formaldehyde in an acidic media with novolak resin. In such resin systems the novolak forms a resol resin in situ in the acidic portions of the coating where the photoacid generator is converted to an acid. Latent formaldehyde generators that are suitable for yielding positive and negative thermally stable images include S-trioxane, N(2-hydroxyethyl)-oxazolidine and oxazolidinylethyl methacrylate. The N(2-hydroxyethyl)-oxazolidine and the oxazolidinylethyl methacrylate are disclosed in detail in US 3,037,006.

Acid hardening phenoplast-containing resin systems can also be formulated by utilizing, in place of the novolak resins, alkali-soluble polyvinylphenols, having weight average molecular weights of about 2000 to

about 50,000, preferably about 2000 to about 20,000. The latent formaldehyde generator or phenoplast may, for example, be present in the acid hardening resin system, in an amount of about 3 to about 30 percent by weight, based on the weight of the novolak or polyvinylphenol resin.

In one embodiment of the invention, the acid hardening resin system of the coating composition and/or coating comprises phenoplast resin and formaldehyde generating compound with the phenoplast being present in an amount of 50 to 95 parts by weight and the formaldehyde generating compound being present in an amount of 40 to 3 parts by weight, and the photoacid generator of the coating composition and/or coating is present in an amount of 2 to 30 parts by weight.

The storage stabilities of the aminoplast-based acid hardening resins have been found to be generally superior to the storage stability of the phenoplast-based acid hardening resins.

A number of photoacid generators have been found to be useful in the practice of this invention when used at concentrations of about 5 to about 50 weight percent based on the total solids content of the coating. O-naphthoquinone diazides have been found to be preferred photoacid generators in the photosensitive coating compositions of the invention, and these diazides may, for example, be esters of naphthoquinone diazide sulfonic acids represented by the general structural formula I.

I

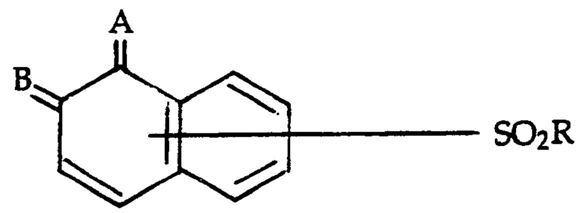

where A is $N_2$ or O and B is O when A is $N_2$, and B is $N_2$ when A is O, and where R is a residue or polymer having a hydroxy or amino group. Examples of naphthoquinone diazides and polymers of this type which are suitable in the present invention are disclosed in the following US patents listed here for reference: US 2,766,118; 2,767,092; 3,046,118; 3,046,121; 3,046,123; 3,106,465; 3,148,983; 3,189,733; 3,201,239; 3,635,709; 3,640,992; 3,661,582; 3,666,473; 3,732,273; 3,759,711; 3,785,825; 3,890,152; and 4,308,368.

The photoacid generator may, for example, comprise o-naphthoquinone diazide sulfonic acid derivative.

In one embodiment of the present invention the photoacid generator may, for example, comprise one or more aliphatic alcohol ester of naphthoquinone diazide sulfonic acids.

We have found that aliphatic alcohol esters of naphthoquinone diazide sulfonic acids are not only effective photoacid generators but can also act to cause rapid hardening or crosslinking of the acid hardening resin-containing photosensitive coating compositions during a hardbaking step. It is believed that these esters are particularly effective at temperatures of about 100 to 200° C and above, because at these temperatures they pyrolyze generating sulfonic acids which are effective catalysts for the acid hardening resin system.

An aliphatic sulfonic acid ester photo generator, for example in an amount of as low as 2 weight percent, e.g. from 2 to 5 weight percent, based on the total solids content of the coating, when added to about 10 to about 28 weight percent, e.g. about 25 weight percent, of a naphthoquinone diazide sulfonic acid ester is particularly effective for improving the thermal stability of both the positive and negative images of the invention.

Non-reacting solvents which have been found to be useful in the photosensitive coating compositions include one or more of glycol ethers, such as ethylene glycol monomethylether, ethylene glycol monoethylether and Proposol B and P; Cellosolve esters, such as methyl Cellosolve acetate, ethyl Cellosolve acetate, and the acetates of Proposol B and P; aromatic hydrocarbons; such as toluene and xylene; ketones, such as methylethyl ketone, cyclopentanone and cyclohexanone; esters, such as ethylacetate, butyl acetate, isobutyl isobutyrate and butyrolactone; amides, such as dimethyl acetamide (DMAC), N-methyl pyrrolidone (NMP) and dimethyl formamide (DMF) chlorinated hydrocarbons, such as ethylene dichloride, chlorobenzene and ortho-dichlorobenzene; nitrobenzene; dimethylsulfoxide. Such solvents may, for example, contain minor amounts of other suitable compounds.

The photosensitive coating solution may, for example, contain at least 50 percent by weight solvent, preferably about 65 to 95 percent by weight, solvent, the percentages being based on the total weight of the solids. Conveniently, the solvent system does not react adversely with the other components in the coating solution and the coating formed therefrom is of a homogeneous nature, e.g. free from sediment, crystallized

components, particulates and dirt.

Various additives can also be incorporated in the photosensitive coating composition in minor amounts, e.g. from about 0.001 percent to about 10 percent by weight, based on the weight of total solids, to enhance the performance of the coating composition and the resulting coating or film. These additives can act as flow and leveling agents, anti-striation agents, plasticizers, compatibilizing agents, and/or anti-reflection dyes. The dyes, on exposure of the coating to actinic radiation, increase resolution and inhibit back scattering of light reflected from the substrate surface. Weak organic acids such as acetic, propionic, tartaric, malonic, succinic, glutaric or phthalic, may be added, e.g. at concentrations of about 0.001 to about 2 percent by weight of solids, to adjust the acidity of the coating composition to neutral or slightly acidic in order to assist in stabilizing the composition against alkaline decomposition. In addition, small quantities of water, e.g. of the order of about 0.001 to 1 percent, based on the total weight of the coating composition, can also be added to assist in the decomposition of the exposed photoacid generator. Monomeric low molecular weight alcohols and/or glycol ethers can also be added, e.g. at about 1 to about 20 weight percent based on the total weight of the coating composition, to stabilize the aminoplast resin, if such resin is present.

The thermally stable images may, for example, be prepared by the addition of acid hardening resin, for example 20 weight percent Cymel 303, based on the weight of the solids in the coating, to commercially available conventional novolak resin solution containing naphthoquinone diazide photoacid generator. Suitable naphthoquinone diazide photoacid generators include: Eastman Kodak Company's Kodak 809 and 820 photoresists; J. T. Baker Chemical Company's PR-20 photoresist; Philip A. Hunt Chemical Corporation's Waycoat HPR 104, 106, 204, 206 and 254 photoresists; Shipley Company Inc.'s AZ 1350, AZ 1350B, AZ 1350J, AZ 1350H, AZ 1470, AZ 2400, AZ 111, AZ 23M and AZ 3000 photoresists; Polychrome Corporation's PC-129, PC-1295F and PC-138 photoresists; Fuji Chemicals Industries Company's FFPR 200 photoresist, and Tokyo Onka Kogyu Company Ltd.'s OFPR-800 photoresist.

The thermally stable, dual developable, photosensitive coating compositions, used in the invention may, for example, be applied to a substrate surface as a solution coating by any conventional coating technique such as spin coating, spray coating or dip coating. Coatings of about 0.5 to about 50 micrometers in thickness can be adherently deposited to substrate surfaces by these techniques.

For example, when spin coating is utilized, the solids content of the coating solution can be adjusted to provide the film with the thickness desired based on the type of spinning equipment utilized, the viscosity of the solution, and the amount of time allowed for the spinning process.

When the photosensitive coating compositions are used as photoresists, spin coating of the solution coating is particularly suitable for depositing an adherent, uniform film on the surface of a substrate, for example, the surface of silicon or silicon dioxide coated wafers used in the production of microprocessors and other miniaturized integrated circuit components. Aluminum-aluminum oxide and silicon nitride wafers can also be coated using the photosensitive coatings of the invention resulting in excellent film adhesion.

Both positive and negative images having resolutions as low as about 0.7 micrometers can be prepared from a one to five micrometer thick film. It has been found that highly resolved narrow spaces can be formed in planarizing films such that the aspect ratio, i.e. the ratio of film thickness to the width of the space between adjacent film areas, is at least 6:1 and possibly greater than 10:1.

Electronic devices, such as silicon wafers containing complete electronic circuits, can be coated with the photosensitive coating composition, e.g. using the above techniques, to provide protection and insulation for the electronic components. These protective coatings reduce the effects of dirt, electrical contaminants, moisture, alpha particles and handling damage, while at the same time permitting certain areas of the coating to be removed for the purpose of attaching electrical contacts. When it is desired to clear the coating from certain areas of the surface of a substrate, e.g. in order to subsequently make electrical connections, these areas can be cleared by utilizing steps (d) and (e) of the process of the invention described above for producing positive or negative images, the thermally stable protective coating being left in the remaining areas on the substrate surface. In addition, these coatings may serve as useful dielectric and insulating layers for electronic devices.

Planarizing films or layers, e.g. up to about 10 micrometers in thickness can also be deposited on substrate surfaces, for example on surfaces of microelectronic devices and aluminum relief structures, using the above techniques.

We have found that because the photosensitive coating composition can be applied as an adherent, uniform film of desired thickness on a substrate surface, the coating is particularly useful in forming thermally stable planarizing layers on surfaces. Accordingly, the coating can be applied, to substrate surfaces of non-uniform topography, as a protective coating or photoresist of thickness sufficient to uniformly protect all the surface irregularities.

In addition, since the coating is thermally stable and capable of micron to submicron image resolution, multiple thermally stable images can be built, one on top of the other, so as to form a three dimensional grid matrix. A matrix of sets of parallel lines may, for example, thus be formed, each set intersecting the previous set of lines at angles relative to the previous set varying from a right angle to nearly parallel, with subsequent sets optionally being parallel to other sets so long as they intersect at least one previous set. In this manner, a thermally stable screen or filter can be formed on the surface. In addition, as a result of the thermal stability and high image resolution achievable with the photosensitive coating composition, two dimensional filters can also be prepared in accordance with the invention.

After the coating composition has been applied to the substrate surface, the substrate can be baked to remove residual solvent forming a film or coating. The residual solvent level is preferably accurately controlled in order that reproducible results during the subsequent exposure and development steps may be achieved. Baking the substrate containing the solution coating at about 90° C to about 100° C for about 30 minutes has been found to satisfactorily dry the film. Alternative methods, such as hot-plate heating with controlled times and temperatures, can also give suitable results.

The dried film, which is substantially free of solvent, should generally be touch-tack free (TTF) so that dust and dirt will not accumulate by adhesion to the film. TTF formation aids in preventing adhesion of the coated substrate to a photomask during contact exposure. If a TTF film has been formed, after drying, cotton fibers of a small cotton ball do not cling to the film when touched thereto.

When the photosensitive coating composition is used as a photoresist to form thermally stable images on silicon wafers, it is preferred to pretreat the wafers with a silylamine derivative, such as hexamethyldisilazane or chloromethylsilane.

After the photosensitive film is deposited on a substrate surface and exposed, eg, by convential techniques, to actinic radiation, eg, through a photomask, the film can be developed to form a positive or a negative image.

When producing a thermally stable positive image, the exposed photosensitive film, containing an acid latent image area, is developed, eg, using a suitable aqueous base developer solution. The previously unexposed portions of the film are then flood exposed to the actinic radiation to form a second acid latent image in the previously unexposed areas. This acid containing image can then be crosslinked by heating to form a crosslinked, thermally stable, high quality, positive image.

When producing a thermally stable negative image, the acid latent image, in the exposed photosensitive film areas, is heated to from 70° C to 120° C to form a thermoset or hardened image. The previously unexposed portions of the film are then flood exposed to the actinic radiation forming therein a second add latent image which can be developed using an aqueous base developer solution. The remaining thermoset image can then be heated (hard baked) to temperatures from about 100 to about 125° C to form a high quality, thermally stable, negative image.

In the practice of the process of the invention aqueous solutions of inorganic alkalis, such as sodium hydroxide, potassium hydroxide, sodium carbonate, sodium bicarbonate, sodium silicate, sodium metasilicate or aqueous ammonia or aqueous solutions or organic alkali, such as primary amines; for example ethylamine or n-propylamine; secondary amines, for example diethylamine or di-n-propyl amine; tertiary amines, for example triethylamine or methyldiethylamine; alcohol amines, for example dimethylethanolamine or triethanolamine; quaternary ammonium hydroxides, for example tetramethylammonium hydroxide or tetraethylammonium hydroxide; cyclic amines for example pyrrole, piperidine, 1, alpha-diazabicyclo (5,4,0)-7-undecane (DBV) or 1,5-diazabicyclo (4,3,0)-5-nonane (DBN) can be utilized as developer. In addition, minor amounts, eg, about 0.1 to about 20 weight percent of the developer solution, of water soluble organic solvent, for example, methanol, ethanol, isopropanol, n-propanol or Cellosolve or a surfactant, may be added to the aqueous base developer. Other developers suitable for use in the practice of the process of the invention are disclosed in US patents 3,110,596; 3,173,788; 3,586,504 and 4,423,138.

After a thermally stable crosslinked image is formed on the substrate surface, a second photosensitive film may, for example, be applied directly over the first image and onto the remaining portions of the substrate and processed again to form planarizing layers or multiple images of different resolutions on the surface.

If the crosslinked positive or negative image is desired to be removed from the substrate surface, the image may be stripped using oxygen plasma treatment or by the use of a stripping solution at elevated temperatures of the order of 75° C to about 180° C. Suitable stripping solutions include N-methylpyrolidone (NMP), dimethyl sulfoxide, dimethyl formamide or NMP and the monomethyl ether of ethylene glycol and the like as disclosed in US 4,428,871.

The present invention will now be further illustrated by way of the following Examples and with reference to the accompanying drawings, it being understood that the Examples and drawings are merely

illustrative of the present invention and are not to be construed as imposing any limitation on the scope of the invention.

In the drawings, which are all photographs taken at 10,000 magnification with a scanning electron microscope:-

Figure 1 is a photograph of a positive image formed according to the present invention;

Figure 2 is a photograph of a thermally stable positive image formed according to the present invention after heating to 300° C;

Figure 3 is a photograph of a negative image formed from the photosensitive coating composition used to prepare the positive images of Figures 1 and 2;

Figure 4 is a photograph of a thermally stable negative image formed from the photosensitive coating composition used to prepare Figures 1-3 after heating to 300° C;

Figure 5 is a photograph of a three dimensional grid matrix planarizing image layer formed according to the present invention;

Figure 6 is also a photograph of a planarizing image formed according to the present invention;

Figure 7 is a photograph of a 4 micrometer thick negative image formed according to the invention; and

Figure 8 illustrates the thermally stable image of Figure 7 after heating to 300° C.

Example 1 presents a general procedure for preparing thermally stable positive and negative images on a silicon wafer from a photosensitive coating composition of the invention. This general procedure was followed for all the other examples illustrated in Table 1 with modifications indicated therein.

EXAMPLE 1: Positive and Negative Images on a Silicon Wafer

To 10 grams of a commercially available proprietary photosensitive mixture, Shipley Company Microposit 1470 photoresist, containing a novolak resin and a diazonaphthoquinone photoacid generator dissolved in a suitable organic solvent system, at 25° C was added 0.54 grams of a methylated melamine-formaldehyde aminoplast, Cymel 303. The photosensitive coating composition was stirred for about 15 minutes at 25° C until a homogeneous solution was formed. The surface of a 7.62 cm (3 inch) diameter silicon oxide coated wafer was first primed with 1.60 milliliters of hexamethyl silazane to remove surface moisture. The photosensitive coating solution was then spin coated onto the primed wafer surface at 3000 rpm for 60 seconds.

The coated wafer was then heated in a forced air oven for 30 minutes at 90° C to remove residual solvent and dry the film (TTF).

(a) Formation of Positive Image

The wafer containing the dried TTF photosensitive film was then placed in contact with a photomask having 4 micron lines and spaces. The film was then exposed to actinic radiation at 365 nanometers from a high pressure mercury vapor lamp at a radiation dose level of 63 millijoules per square centimeter ($mJ/cm^2$) using a Hybrid Technology Group Model No. L 84-5X contact printer with a 500 watt lamp. Following exposure and the removal of the photomask, the acid latent image in the exposed areas of the film was developed by placing the wafer in a conventional aqueous base developer, Shipley Company Microposit 351 Developer, diluted one part by volume with 4 parts by volume deionized water, for 1.5 minutes at 25° C with mild agitation of the wafer forming a positive image of 1.7 micrometers in thickness. This positive imaged wafer could be used in low temperature fabrication operations without further treatment.

In order to form a thermally stable positive image, the image formed on the surface was then flood exposed to actinic radiation of 365 nanometers using a high pressure mercury vapor lamp at a radiation dose level of 1.0 Joules per square centimeter. The flood exposed image containing the photogenerated acid was then heated in a forced air oven for 30 minutes at 100° C to crosslink the image.

The hardened images were then heated for an additional 30 minutes each at temperatures of 300° C, 350° C and 400° C. No significant loss in image quality was observed in scanning electron micrographs (SEM's) taken of the image before and after heating to these high temperatures. The thermally stable images before and after heating are illustrated in Figures 1 and 2.

The images were assigned a relative rating of 1 to 5 based on the image quality. A rating of 5 means that the image quality was excellent and that very sharp edges were obtained. A rating of 4 means that the image was not as sharply defined as an image rated as 5 as there was some rounding of the images but the images were still of high quality. A rating of 3 means that the image quality was acceptable, there being slightly more rounding of the edges of the image but the image remained stable and did not flow upon heating. A rating of 2 means that the image was of borderline quality, there being distortion of the image on

heating but no significant image flow. A rating of 1 means that the image was not acceptable, there was significant image flow upon heating. A rating of 0 means that no image was observed or that the image formed flowed readily upon heating.

(b) Negative Image

A coated wafer as in Example 1 (a) was placed in contact with a photomask having 4 micron lines and spaces and was exposed to actinic radiation of 365 nanometers using a high pressure mercury vapor lamp at a radiation dose level of 100 mJ/cm$^2$ using the same printer described above. The exposed wafer-containing the acid latent image in the exposed film areas, was then heated in a forced air oven to 100 °C for 15 minutes. After the wafer was cooled to ambient temperature, the entire coating was flood exposed to 365 nanometer radiation at a dose level of 100 mJ/cm$^2$ using the high pressure mercury vapor lamp. The negative image was then developed at 25 °C by placing the wafer in the 4/1 diluted sodium hydroxide-containing aqueous developer, Shipley Company Microposit 351 Developer, for one minute with mild agitation. The developed negative image was then evaluated by viewing the SEN (Figure 3). The image quality as a function of development time was evaluated by placing the developed negative image-containing wafer in the developing solution for an additional 2 minutes. The image quality was found to be virtually unaffected by elongation of the development time.

Portions of the negative imaged wafer were heated to 300 °C for 30 minutes and retention of image quality was observed. The SEM of the thermally stable negative image after baking to 300 °C is Presented in Figure 4.

(c) Thermal Stability of the Photosensitive Coating Solution

A solution of the photosensitive coating solution prepared according to Example 1(a) was placed in a tightly capped bottle and heated for 10 days at 50 °C. The viscosity of the coating solution and the quality of positive and negative images prepared from this solution were compared with the viscosity and image quality obtained in Examples 1(a) and 1(b). Virtually no change in image quality or viscosity of the coating solution was observed by this thermal stability test.

The strippability of the thermally stable positive and negative images formed on the surface was demonstrated by immersing the imaged surfaces in dimethylformamide at about 150 °C for about one minute. Upon removal of the surfaces from this solution no images were microscopically observed on the surfaces.

EXAMPLE 2: Planarizing Layer Images

To 100.00 grams of the Shipley Company Microposit 1470 photoresist was added 5.40 grams of Cymel 303 aminoplast. A coating of about 1.7 microns in thickness was prepared on a silicon oxide wafer according to the procedure of Example 1(a). After drying the coating for 30 minutes at 90 °C, the coated wafer was exposed to actinic radiation of 365 nanometers at a dose level of 100 mJ/cm$^2$ through a photomask having 4 micron lines and spaces. The wafer was then heated for 15 minutes at 100 °C, cooled to ambient temperature and flood exposed to 365 nanometers actinic radiation at a dose level of 100 mJ/cm$^2$. The negative image was developed at 25 °C for 90 seconds in Shipley Company 351 Developer diluted 1 part Shipley 351 to 3 parts deionized water by volume.

The wafer containing the negative image was then recoated by spin coating a mixture of 100.00 grams of Shipley Company Microposit 1450J novolak resist with 6.20 grams of Cymel 303 over the imaged wafer. The recoated wafer was dried as indicated for the first coating and exposed to 365 nanometers actinic radiation at a radiation dose level of 400 mJ/cm$^2$ by positioning the photomask at 90 degrees to the original image pattern. After heating the recoated exposed film for 15 minutes at 100 °C. the wafer was cooled to 25 °C and flood exposed to 365 nanometer actinic radiation at a radiation dose level of 400 mJ/cm$^2$. The exposed film was then developed for 60 seconds in the same developer used above in preparing the first image, followed by a second development in Shipley 351 developer diluted 1 part with 2 parts by volume deionized water for 30 seconds.

The SEM of the planarized imaged wafer is illustrated in Figure 5. This figure shows a sharply resolved cross-patterned thermally stable image structure on grid matrix with precisely formed perpendicular lines and spaces. Each pair of perpendicular lines define both a precise area on the wafer surface and a precise volume measured by the area on the wafer surface multiplied by the height of the first image above the surface. In addition, the points at which the top image crosses the lower image are uniform with respect to

the line width and are substantially perpendicular to the lower image at all points.

The second coating of photoresist therefore forms a substantially flat planarizing surface over the imaged wafer which can then be precisely imaged and developed to form uniform images over the existing images.

EXAMPLE 3: Planarizing Images

A silicon oxide wafer was coated, imaged and processed as in Example 2 to form a negative image of 4 micron lines and spaces with a height of 1.6 microns above the wafer surface. A second coating was prepared by dissolving 40.00 grams of an 8000 weight average molecular weight cresol novolak resin in 60.00 grams of Shipley Microposit thinner solvent followed by the addition of 13.33 grams of 1-oxo-2-diazonaphthalene-5-sulfonic acid ester and 8.00 grams of Cymel 303. This coating solution was then applied to the imaged wafer surface and the coating was dried at 90 °C for 30 minutes to form a TTF film and exposed to 365 nanometers radiation at 600 mJ/cm$^2$ radiation dose level through a photomask positioned with its lines and spaces at right angles to the original image lines. After the second image coating was heated to 90 °C for 30 minutes, the second coating was exposed through a photomask to the same radiation wavelength and dose level as used for exposing the first film. The second image was then developed for 90 seconds in Shipley Microposit 351 diluted 1 part to 2 parts deionized water by volume, followed by a second development for 60 seconds in the same developer diluted 1 part developer to 1 part deionized water by volume. The SEM of the planarized image is shown in Fig. 6. The height of the second relief image above the surface was measured and found to be 7.3 microns.

EXAMPLE 4: Polyglutarimide Containing Photosensitive Composition

(a) Preparation of Polyglutarimide

A polyglutarimide was prepared in a continuous extrusion device according to the process described in US patent 4,246,374. A high molecular weight polymethyl methacrylate homopolymer was introduced via the feed port of a twin-screw counter-rotating extruder at a rate of 1.36 x $10^{-2}$ kg/s (108 pounds per hour). Ammonia was introduced into the extruder barrel at a rate of 5.13 x $10^{-3}$ kg/s (40.7 pounds per hour) at a pressure of 9.65 MPa (1400 psig). The ammonia contacted and mixed with the polymethyl methacrylate as it moved forward through the reaction zone at an extruder rpm of 225. The average barrel temperature was 293.3 °C (560 °F). The unreacted reagents and volatile products and by-products of the reaction were removed under vacuum at the vent. The imidized polymer product left the extruder through the die in melt form, non-foamed and essentially free of volatile materials. The polyglutarimide had a weight average molecular weight of 71,000 as determined by gel permeation chromatography and contained 58 mole percent ammonia-derived (N-H) glutarimide units and 42 mole percent methylamine-derived (N-$CH_3$) glutarimide units. The Vicat temperature of the polyglutarimide was measured (ASTM DI 525-70) to be 199 °C and the glass transition temperature, measured by Differential Scanning Calorimetry, had a mid point between 192 and 193 °C.

(b) Coated Wafer

A solution was prepared by dissolving 20.00 grams of the polyglutarimide in 80.00 grams of dimethylformamide (DMF) followed by the addition of 4.00 grams of Cymel 303 aminoplast and 5.00 grams of a diazonaphthoquinone sulfonate ester photoacid generator followed with stirring at room temperature until the components completely dissolved. The solution was then diluted by adding an additional 20.00 grams of DMF to form the desired photosensitive coating composition. The coating composition was spin coated on a primed silicon dioxide coated wafer at 3000 rpm for 60 seconds, followed by drying the film at 90 °C for 30 minutes.

(c) Image Formation

Both positive and negative images were then prepared following the procedures of Examples 1(a) and 1(b), respectively. Both sets of images showed sharply resolved 4 micron lines and spaces with an image height of about 1.5 microns from the wafer surface. The imaged wafers were heated to 200 °C for 30 minutes without significant loss of image resolution or quality (rating = 3).

EXAMPLE 5: Thermally Stable Dual Image

To a solution of 8.00 grams of a polymeric photoacid generator (diazonaphthoquinone ester as in US 4,308,368 preparation Example B) dissolved in 120 grams of methylethyl ketone and 50 grams of methyl cellosolve acetate was added 16.00 grams of a predominantly m-cresol novolak resin and 4.80 grams of Cymel 303 aminoplast. The photosensitive coating composition was spin coated on a primed silicon oxide wafer and processed according to the procedures of Example 1 to yield good quality (rating = 3) positive and negative images that were thermally stable when heated for 30 minutes at 200° C.

EXAMPLE 6: Phenoplast Containing Photosensitive Coating Composition

To 100.00 grams of Shipley Company Microposit 1470 photoresist was added 5.40 grams of N(2-hydroxyethyl) oxazolidine (referred to herein as HEOX) at room temperature with stirring. The preparation of the HEOX is described in US 3,037,006 Example 1a. Silicon oxide wafers were then coated, exposed and developed to form positive and negative images according to the procedure of Example 1. The developed images were of excellent quality rated as 5. Heating the imaged wafers at 300° C for 30 minutes caused some image distortion in both image sets, the rating for the images after heating was acceptable and rated as 3.

EXAMPLE 7: Phenoplast Containing Photosensitive Coating Composition

To 100.00 grams of Shipley Microposit 1470 was added 5.40 grams of oxazolidinylethyl methacrylate (referred to herein as OXEMAE) described in US 3,037,006 Example 1(b). The mixture was stirred until a homogeneous solution was formed and silicon wafers were coated, imaged and developed according to the procedure of Example 1. High quality, rated as 4, positive and negative images were formed on development. The images showed distortion upon heating for 30 minutes at 300° C and were barely acceptable and rated as 2.

EXAMPLE 8: Multiple Photoacid Generator Photosensitive Coating Composition

Example 1 was repeated with the addition of 0.81 grams of a sulfonic acid ester prepared from 1-oxo-2-diazonapththalene-5-sulfonyl chloride and Abitol, an aliphatic alcohol prepared by reducing the carboxyl group and one of the double bonds of abietic acid. Both positive and negative images were prepared following the procedure of Example 1. The images showed good quality (rating 2) when heated for 30 minutes at 450° C.

EXAMPLE 9: Images on Various Substrates

The method of Example 1 for forming positive and negative images was followed using silicon wafers having various surface compositions: silicon oxide, silicon metal, silicon nitride, and aluminized silicon oxide. All the images were heated to 200° C in air for 30 minutes. Thermal stability was rated as 5 for all the imaged substrates after heating, and all images exhibited excellent adhesion to the substrates before and after heat treatment.

EXAMPLE 10-77

Additional examples of dual, positive and negative, thermally stable polymer images formed from the photosensitive coating compositions of the invention utilizing the process described in Example 1 are presented in tabular form in Table 1. These examples illustrate the image quality resulting from variations in the formulations and process variables.

Examples 10 to 32 illustrate positive and negative images formed from a photosensitive coating composition prepared according to the procedures of Examples 1(a) and 1(b) from a Shipley Microposit Photo Resist S1470 novolak-naphthoquinone diazide photoacid generator solution and Cymel 303 or 370 aminoplast. All coatings were dried after deposition onto the substrate, according to Example 1(a), at 90° C for 30 minutes and exposed through a photomask to 365 nanometers actinic radiation at the radiation dose levels specified, and further processed to form positive and negative images according to the procedure of Example 1 as modified where indicated.

Examples 15 and 16 show excellent image quality is obtained when a quaternary ammonium hydroxide

developer, Shipley Microposit Developer 312, is used to prepare positive and negative images.

Examples 33 to 36 utilized the same photoresist solution as in Examples 9 to 31 with Cymel 370 aminoplast. These films were dried and exposed as indicated in Examples 10 to 32 with radiation dose levels as specified in Table 1. Example 32 is directed to a planarizing layer as described previously in Example 2.

Examples 37 and 38 utilized the same photoresist solution as in Examples 10 to 36 with benzoguanamine C1123 aminoplast. The films were also processed as in Example 1 and Examples 10 to 36 with the modifications indicated in Table 1.

Examples 39 and 40 utilized the same photoresist solution as in Examples 10 to 30 with a urea based Beetle 60 aminoplast. The films were processed as in Example 1 with the modifications indicated in the Table.

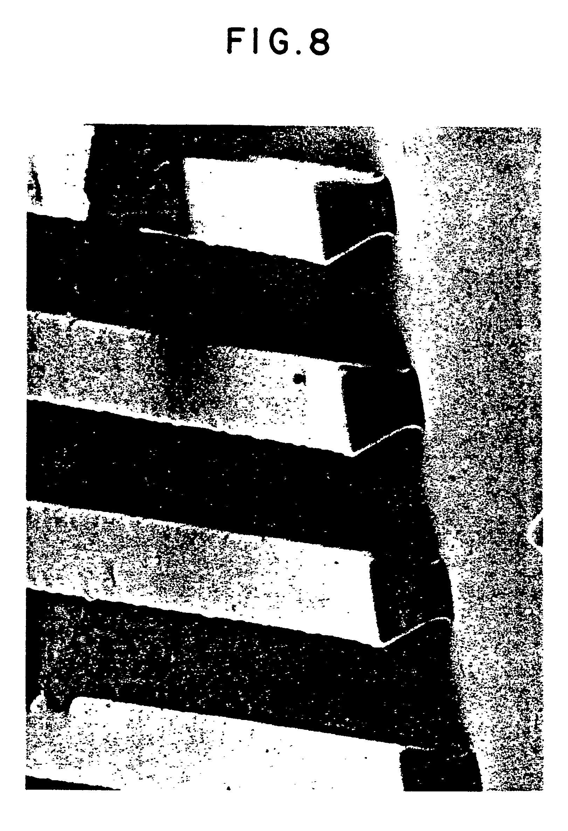

Examples 41 to 46 illustrate the photosensitive coating compositions of the invention prepared from different novolak resist solutions containing naphthoquinone diazide photoacid generator and Cymel 303. Example 43 and Figure 7 illustrates a high quality negative image having a slightly undercut or image profile having a negative slope, such that the width of the image adhering to the surface is smaller than the top of the image. Images of this type are especially useful in preparing microelectronic circuits using a metal-lift off technique. Figure 8 shows that this image is thermally stable after heating to 300 °C for 30 minutes. Note however that Examples 45 and 46 were exposed to actinic radiation of 310 nanometers rather than 365 nanometers.

Examples 48 to 55 illustrate a photosensitive coating composition of the invention employing a polyvinylphenol solution with 25 weight percent naphthoquinone diazide sulfonate ester photoacid generator and Cymel 303 aminoplast. The photosensitive coating compositions of Examples 52 and 53 also contained 3 weight percent, based on the total weight of solids, Abitol ester naphthoquinone diazide sulfonic acid. The films were dried as in the previous Examples and exposed to 365 nanometer actinic radiation.

Examples 56 to 69 are examples of polyglutarimideaminoplast or urea based resins (Examples 68 and 69) photosensitive coatings employing a naphthoquinone diazide sulfonate ester photoacid generator following the procedure of Example 4.

Examples 70 and 71 are directed to novolak (MW 12000) resin - naphthoquinone diazide triester photoacid generators (5 weight percent, based on the total weight of solids) solutions with Cymel 303 aminoplast. These photosensitive coatings were also processed according to Example 1 as indicated in the Table.

Example 72 is a novolak (MW 12000) resin and naphthoquinone diazide triester photoacid generator (25 weight percent, based on the total weight of solids) solution with Cymel 303 dissolved in Shipley Microposit thinner and processed according to Example 1 on an aluminum substrate.

Examples 73-76 are directed to novolak (MW 8000) resin - naphthoquinone diazide sulfonate esters photoacid generator (10 weight percent, 10 weight percent, 5 weight percent and 5 weight percent, respectively, based on total weight of solids) solutions with Cymel 303 processed according to Example 1.

Example 77 is a Comparative Example directed to a photosensitive coating prepared according to US 4,104,070 utilizing Shipley Microposit 1350H photoresist solution (Cresol novolak resin) and 1 weight percent Monazoline-C. This Example was acceptable for preparing a high quality negative image (rated as 5) but the image flowed (rating 0) upon heating to 125 °C for 1 hour clearly indicating that the image was clearly not crosslinked or thermally stable.

TABLE 1

| Ex. | Resin | Acid Hardening System | Ratio (wt) | Image | Thick Micron | Exposure ($mJ/cm^2$) |
|---|---|---|---|---|---|---|
| 10 | S1470[a] | C303[b] | 4/1 | Pos. | 1 | 63 |
| 11 | " | " | " | Neg. | " | 63 |
| 12 | " | " | " | Neg. | " | 100 |
| 13 | " | " | " | Pos. | 1.75 | 63 |
| 14 | " | " | " | Neg. | 1.63 | 100 |
| 15 | " | " | 4/1 | Pos. | 1.5 | 63 |
| 16 | " | " | " | Neg. | 1.7 | 100 |
| 17 | " | C370 | " | Pos. | 1 | 63 |
| 18 | " | " | " | Neg. | 1 | 100 |
| 19 | " | C303 | 9/1 | Pos. | 1.6 | 63 |
| 20 | " | " | " | Neg. | 1.1 | 100 |
| 21 | " | " | " | Pos. | 1 | 63 |
| 22 | " | " | " | Neg. | 1 | 100 |
| 23 | " | " | 19/1 | Pos. | 1.5 | 63 |
| 24 | " | " | " | Neg. | 1.2 | 100 |
| 25 | " | " | 4/1 | Neg. | 1 | 100 |
| 26 | " | " | " | Neg. | 1 | 100 |
| 27 | " | " | " | Neg. | 6 | 400 |
| 28 | " | " | " | Neg. | 1.03 | 100 |
| 29 | " | " | " | Neg. | 1.03 | 200 |
| 30 | " | " | " | Neg. | 1.5 | 200 |
| 31 | " | " | " | Neg. | 1.5 | 200 |
| 32 | " | " | " | Neg. | 3 + 3 | 100 |
| 33 | " | C370[c] | 9/1 | Pos. | 1.5 | 63 |
| 34 | " | " | " | Neg. | 1.5 | 100 |
| 35 | " | " | 19/1 | Pos. | 1.5 | 63 |
| 36 | " | " | " | Neg. | 1.5 | 100 |
| 37 | " | C1123[d] | 4/1 | Pos. | 1.5 | 63 |
| 38 | " | " | " | Neg. | 1.5 | 100 |
| 39 | " | B-60[e] | 4/1 | Pos. | 1.5 | 63 |
| 40 | | " | " | Neg. | 1.5 | 100 |
| 41 | S1450J[f] | C303 | 4/1 | Neg. | | 400 |
| 42 | " | " | " | Pos. | 4 | 500 |
| 43 | " | " | " | Neg. | 4 | 500 |

TABLE 1 Cont.

| Ex. | Resin | Acid Hardening System | Ratio (wt) | Image | Thick Micron | Exposure ($mJ/cm^2$) |
|---|---|---|---|---|---|---|
| 44 | S2400[g] | C303 | 4/1 | Pos. | 1 | 63 |
| 45 | " | " | " | Neg. | 1 | 100 |
| 46 | S3000[h] | C303 | 4/1 | Pos. | 1 | 200 |
| 47 | " | " | " | Neg. | 1 | 100 |
| 48 | PVP | C303 | 4/1 | Pos. | 1.7 | 63 |
| 49 | " | " | " | Neg. | 1.4 | 100 |
| 50 | " | " | " | Pos. | | 63 |
| 51 | " | " | " | Neg. | | 100 |
| 52 | " | " | " | Pos. | | |
| 53 | " | " | " | Neg. | | |
| 54 | " | " | " | Pos. | 1.4 | |
| 55 | " | " | " | Neg. | 1.3 | |
| 56 | PG[i] | C303 | 1/1 | Pos. | 1 | 63 |
| 57 | " | " | " | Neg. | | 100 |
| 58 | PG[j] | " | 2/3 | Pos. | 2.7 | 100 |
| 59 | " | " | " | Neg. | 1.4 | 100 |
| 60 | " | C370 | 4/1 | Pos. | 1.3 | 63 |
| 61 | " | " | " | Neg. | 1.1 | 100 |
| 62 | " | " | 2/3 | Pos. | 1.4 | 63 |
| 63 | " | " | " | Neg. | 1.6 | 100 |
| 64 | PG[k] | C370 | 2/3 | Pos. | 1.3 | 63 |
| 65 | " | " | " | Neg. | 0.9 | 100 |
| 66 | " | C303 | 2/3 | Pos. | 1.5 | 63 |
| 67 | " | " | " | Neg. | 0.9 | 100 |
| 68 | " | B60 | 1/1 | Pos. | 1 | 63 |
| 69 | " | " | " | Neg. | 1 | 100 |
| 70 | XP0103[l] | C303 | 4/1 | Pos. | 1 | 100 |
| 71 | " | " | " | Neg. | 1 | 100 |
| 72 | XP1119[m] | " | 4/1 | Neg. | 7.3 | 500 |
| 73 | " | C303 | 4/1 | Pos. | 1 | 63 |
| 74 | " | " | " | Neg. | 1 | 100 |
| 75 | " | " | " | Pos. | 1 | 63 |
| 76 | " | " | " | Neg. | 1 | 100 |
| 77 | S1350H[n] | Monazoline C° | | Neg. | 1 | 100 |

TABLE 1 Cont..

| Ex. | Positive Develop[p] Dev. | Dil. | Sec | Negative Bake C° | Hrs | Negative Flood Exp. ($mJ/cm^2$) | Negative Develop Dev. | Dil. | Sec |
|---|---|---|---|---|---|---|---|---|---|
| 10 | | | | -- | -- | ---- | -- | -- | -- |
| 11 | -- | -- | -- | | | | | | |
| 12 | -- | -- | -- | 100 | 0.25 | 100 | S351 | 4/1 | 60 |
| | | | | | | | | 3/1 | 30 |
| 13 | S351 | 3/1 | 60 | -- | -- | ---- | -- | -- | -- |
| | | 2/1 | 90 | | | | | | |
| 14 | -- | --- | -- | 90 | 0.5 | 100 | S351 | 3/1 | 60 |
| | | | | | | | | 2/1 | 30 |
| 15 | S312 | 1.5/1 | 35 | -- | -- | ---- | -- | -- | -- |
| 16 | -- | -- | -- | 90 | 0.5 | 100 | S312 | 1.75/1 | 60 |
| 17 | S351 | 3/1 | 90 | -- | -- | ---- | -- | -- | -- |
| 18 | -- | -- | -- | 90 | 0.5 | 100 | S351 | 4/1 | 60 |
| | | | | | | | | 3/1 | 60 |
| 19 | S351 | 3/1 | 45 | -- | -- | ---- | -- | -- | -- |
| 20 | -- | -- | -- | 90 | 0.5 | 100 | S351 | 4/1 | 45 |
| 21 | S351 | 4/1 | 60 | -- | -- | ---- | -- | -- | -- |
| | | 3/1 | 15 | | | | | | |
| 22 | -- | -- | -- | 100 | 0.25 | 100 | S351 | 4/1 | 60 |
| 23 | | | | -- | -- | ---- | -- | -- | -- |
| 24 | -- | -- | -- | 100 | 0.5 | 100 | S351 | 5/1 | 60 |
| 25 | -- | -- | -- | 100 | 0.25 | 100 | S351 | 4/1 | 60 |
| | | | | | | | | 3/1 | 15 |
| 26 | -- | -- | -- | 100 | 0.25 | 100 | S351 | 4/1 | 60 |
| | | | | | | | | 3/1 | 15 |
| 27 | -- | -- | -- | 90 | 0.5 | 400 | S351 | 3/1 | 60 |
| | | | | | | | | 2/1 | 60 |
| 28 | -- | -- | -- | 90 | 0.5 | 100 | S351 | 4/1 | 120 |
| | | | | | | | | 3/1 | 15 |
| 29 | -- | -- | -- | 90 | 0.25 | 200 | S351 | 4/1 | 45 |
| 30 | -- | -- | -- | 90 | 0.5 | 200 | S351 | 4/1 | 60 |
| | | | | | | | | 3/1 | 30 |
| 31 | -- | -- | -- | 90 | 0.5 | 200 | S351 | 4/1 | 0 |
| 32 | -- | -- | -- | 90 | 0.5 | 100 | S351 | 4/1 | 90 |
| 33 | S351 | 3/1 | 40 | -- | -- | ---- | -- | -- | -- |
| 34 | -- | -- | -- | 100 | 0.25 | 100 | S351 | 4/1 | 60 |
| | | | | | | | | 3/1 | 15 |
| 35 | S351 | 4/1 | 55 | -- | -- | ---- | -- | -- | -- |
| 36 | -- | -- | -- | 100 | 0.25 | 100 | S351 | 4/1 | 30 |
| 37 | S351 | 1/1 | 90 | -- | -- | ---- | -- | -- | -- |
| 38 | -- | -- | -- | 100 | 0.25 | 100 | S351 | 2/1 | 75 |
| 39 | S351 | 4/1 | 40 | -- | -- | ---- | -- | -- | -- |
| 40 | -- | -- | -- | 100 | 0.25 | 100 | S351 | 5/1 | 45 |
| 41 | -- | -- | -- | 90 | 0.5 | 400 | S351 | 3/1 | 90 |
| 42 | S351 | 2/1 | 60 | -- | -- | ---- | -- | -- | -- |
| 43 | -- | -- | -- | 100 | 0.25 | 500 | | | |

TABLE 1 Cont..

| Ex. | Positive Develop Dev. | Dil. | Sec | Negative Bake C° | Hrs | Negative Flood Exp. $(mJ/cm^2)$ | Negative Develop Dev. | Dil. | Sec |
|---|---|---|---|---|---|---|---|---|---|
| 44 | S351 | 1/1 | 120 | -- | -- | ---- | -- | -- | -- |
| 45 | -- | -- | -- | 90 | 0.5 | 100 | S351 | 1/1 | 45 |
| 46 | S351 | 1/1 | 150 | -- | -- | ---- | -- | -- | -- |
| 47 | -- | -- | -- | 90 | 0.5 | 100 | S351 | 1/1 | 60 |
| 48 | S351 | 11/1 | 60 | -- | -- | ---- | -- | -- | -- |
| 49 | -- | -- | -- | 90 | 0.5 | 100 | S351 | 10/1 | 30 |
| 50 | -- | -- | -- | -- | -- | ---- | -- | -- | -- |
| 51 | -- | -- | -- | 90 | 0.5 | 100 | | | |
| 52 | | | | -- | -- | ---- | -- | -- | -- |
| 53 | -- | -- | -- | 90 | 0.5 | 100 | | | |
| 54 | S312 | 6/1 | 35 | -- | -- | ---- | -- | -- | -- |
| 55 | -- | -- | -- | 90 | 0.5 | 100 | S312 | 5/1 | 25 |
| 56 | S351 | 3/1 | 60 | -- | -- | ---- | -- | -- | -- |
| 57 | -- | -- | -- | 100 | 0.25 | 100 | S351 | 4/1 | 60 |
| 58 | S351 | 12/1 | 135 | -- | -- | ---- | -- | -- | -- |
| 59 | -- | -- | -- | 100 | 0.5 | 100 | S351 | 12/1 | 60 |
| | | | | | | | | 10/1 | 180 |
| 60 | S351 | 8/1 | 65 | -- | -- | ---- | -- | -- | -- |
| 61 | -- | -- | -- | 100 | 0.25 | 100 | S351 | 9/1 | 60 |
| 62 | S351 | 7/1 | 150 | -- | -- | ---- | -- | -- | -- |
| 63 | -- | -- | -- | 100 | 0.25 | 100 | S351 | 7/1 | 120 |
| | | | | | | | | 4/1 | 60 |
| 64 | S351 | 11/1 | 120 | -- | -- | ---- | -- | -- | -- |
| | | 9/1 | 35 | | | | | | |
| 65 | -- | -- | -- | 100 | 0.5 | 100 | S351 | 9/1 | 60 |
| | | | | | | | | 7/1 | 60 |
| 66 | S351 | 13/1 | 60 | -- | -- | ---- | -- | -- | -- |
| 67 | -- | -- | -- | 100 | 0.25 | 100 | S351 | 9/1 | 60 |
| 68 | S351 | 10/1 | 50 | -- | -- | ---- | -- | -- | -- |
| 69 | -- | -- | -- | 100 | 0.25 | 100 | S351 | 15/1 | 30 |
| 70 | S351 | 2.5/1 | 65 | -- | -- | ---- | -- | -- | -- |
| 71 | -- | -- | -- | 100 | 0.25 | 100 | S351 | 2.5/1 | 95 |
| 72 | -- | -- | -- | 100 | 0.25 | 500 | S351 | 3/1 | 60 |
| | | | | | | | | 2/1 | 60 |
| | | | | | | | | 1/1 | 90 |
| 73 | S351 | 3/1 | 120 | -- | -- | ---- | -- | -- | -- |
| 74 | -- | -- | -- | 90 | 0.5 | 100 | S351 | 3/1 | 60 |
| | | | | | | | | 2.75/1 | 120 |
| 75 | -- | -- | -- | -- | -- | ---- | -- | -- | -- |
| 76 | -- | -- | -- | 100 | 0.25 | 100 | S351 | 2.75/1 | 240 |
| 77 | -- | -- | -- | 105 | 0.17 | 100 | S351 | 1/1 | 60 |

TABLE 1 Cont.

| Ex. | Hardening Bake C° | Hardening Bake Hrs | Heat Resist Test C° | Heat Resist Test Hrs | Image Quality Before/After | Substrate | Mask Lines X Spaces (Microns) |
|---|---|---|---|---|---|---|---|
| 10 | | | 300 | 0.25 | 4/3 | $SiO_2$ | 4 x 4 |
| 11 | 100 | 0.5 | 300 | 0.25 | 5/5 | " | " |
| 12 | 125 | 1.0 | 400 | 0.25 | 4/3 | " | " |
| 13 | 100 | 0.5 | 300 | 0.25 | 5/4 | | |
| 14 | 125 | 1.0 | 300 | 0.25 | 4/3 | | |
| 15 | 100 | 0.5 | 300 | 0.25 | 5/4 | $SiO_2$ | 4 x 4 |
| 16 | 125 | 1.0 | 300 | 0.25 | 5/4 | " | " |
| 17 | 100 | 0.5 | 400 | 0.25 | 5/5 | $SiO_2$ | 4 x 4 |
| 18 | 125 | 1.0 | 400 | 0.25 | 4/4 | " | " |
| 19 | 100 | 0.5 | 300 | 0.25 | 4/3 | " | " |
| 20 | 125 | 1.0 | 300 | 0.25 | 4/3 | " | " |
| 21 | 100 | 0.5 | 200 | 0.5 | 5/4 | " | " |
| 22 | 125 | 1.0 | 200 | 0.5 | 5/4 | " | " |
| 23 | 100 | 0.5 | 300 | 0.25 | 5/3 | " | " |
| 24 | 125 | 1.0 | 300 | 0.25 | 3/2 | " | " |
| 25 | -- | -- | -- | -- | 5/- | $Si_3N_4$ | " |
| 26 | -- | -- | -- | -- | 5/- | Al | " |
| 27 | -- | -- | -- | -- | 5/- | Al | " |
| 28 | -- | -- | -- | -- | 5/- | $SiO_2$ | " |
| 29 | -- | -- | -- | -- | 4/- | " | 1 x 1 |
| 30 | -- | -- | -- | -- | 2/- | " | 0.7 x 0.7 |
| 31 | -- | -- | -- | -- | 5/- | " | 1.5 x 1.5 |
| 32 | 125 | 1.0 | -- | -- | 5 | " | |
| 33 | 100 | 0.5 | 300 | 0.5 | 4/3 | " | 4 x 4 |
| 34 | 125 | 1.0 | 300 | 0.5 | 4/3 | " | 4 x 4 |
| 35 | 100 | 0.5 | 200 | 0.5 | 4/2 | " | 4 x 4 |
| 36 | 125 | 1.0 | 200 | 0.5 | 4/3 | " | 4 x 4 |
| 37 | 100 | 0.5 | 340 | 0.25 | 4/3 | " | " |
| 38 | 125 | 1.0 | 340 | 0.25 | 3/3 | " | " |
| 39 | 100 | 0.5 | 200 | 0.5 | 4/3 | " | " |
| 40 | 125 | 1.0 | 200 | 0.5 | 5/2 | " | " |
| 41 | -- | -- | -- | -- | 5/- | $SiO_2$ | 1.5 x 1.5 |
| 42 | 100 | 0.5 | 300 | 0.25 | 3/3 | " | 4 x 4 |
| 43 | 125 | 1.0 | 300 | 0.25 | 5/4 | " | " |
| 44 | 100 | 0.5 | 300 | 0.5 | 4/2 | " | " |
| 45 | 125 | 1.0 | 300 | 0.5 | 4/2 | " | " |
| 46 | 100 | 0.5 | 300 | 0.5 | 4/4 | " | " |
| 47 | 125 | 1.0 | 300 | 0.5 | 4/3 | " | " |
| 48 | 100 | 0.5 | 450 | 0.25 | 3/3 | " | " |
| | | | 500 | 0.25 | 3/2 | | |
| 49 | 125 | 1.0 | | | 5/- | " | " |
| 50 | 100 | 0.5 | 400 | 0.25 | - | " | " |
| 51 | 125 | 1.0 | 400 | 0.25 | - | " | " |

TABLE 1 Cont.

| Ex. | Hardening Bake C° | Hardening Bake Hrs | Heat Resist Test C° | Heat Resist Test Hrs | Image Quality Before/After | Substrate | Mask Lines X Spaces (Microns) |
|---|---|---|---|---|---|---|---|
| 52 | 100 | 0.5 | 400 | 0.25 | - | $SiO_2$ | 4 x 4 |
| 53 | 125 | 1.0 | | | - | " | " |
| 54 | -- | -- | | | - | " | " |
| 55 | -- | -- | | | 5 | " | " |
| 56 | 100 | 0.5 | 300 | 0.33 | 3/1 | " | " |
| 57 | 125 | 1.0 | 300 | 0.33 | 2/1 | " | " |
| 58 | 100 | 0.5 | 300 | 0.25 | 3/1 | " | " |
| 59 | 125 | 1.0 | 300 | 0.25 | 3/1 | " | " |
| 60 | 100 | 0.5 | 300 | 0.25 | 2/2 | " | " |
| 61 | 125 | 1.0 | 300 | 0.25 | 2/1 | " | " |
| 62 | 100 | 0.5 | 300 | 0.25 | 1/1 | " | " |
| 63 | 125 | 1.0 | 300 | 0.25 | 2/2 | " | " |
| 64 | 100 | 0.5 | 300 | 0.25 | 3/2 | " | " |
| 65 | 125 | 1.0 | 300 | 0.25 | 3/1 | " | " |
| 66 | 100 | 0.5 | 300 | 0.25 | 5/2 | " | " |
| 67 | 125 | 1.0 | | | | | |
| 68 | 100 | 0.5 | 200 | 0.5 | 3/2 | | |
| 69 | 125 | 1.0 | 200 | 0.5 | 3/3 | " | " |
| 70 | 100 | 0.5 | -- | -- | 2/- | " | " |
| 71 | 125 | 1.0 | | | 3/- | | |
| 72 | -- | -- | -- | -- | 5/- | Al | " |
| 73 | 100 | 0.5 | 300 | 0.25 | 3/3 | $SiO_2$ | 4 x 4 |
| 74 | 125 | 1.0 | 300 | 0.25 | 3/3 | " | " |
| 75 | 100 | 0.5 | 300 | 0.25 | 2/2 | " | " |
| 76 | 125 | 1.0 | 300 | 0.25 | 2/2 | " | " |
| 77 | -- | -- | 125 | 1.0 | 5/0 | " | " |

Notes

a - S1470 Shipley Microposit Photoresist 1470
b - C-303 Cymel 303 Am. Cyanamid Co. methylated melamine formaldehyde resin
c - C-370 Cymel 370 Am. Cyanamid Co. methylated melamine formaldehyde resin
d - C-1123 Cymel 1123 Am. Cyanamid Co. methylated benzoguanamine formaldehyde resin
e - B60 Beetle 60 Am. Cyanamid Co. methylated urea formaldehyde resin
f - S1450J Shipley Microposit Photoresist 1450J
g - S-2400 Shipley Microposit Photoresist 2400
h - S-3000 Shipley Microposit Photoresist 3000
i - PG 1 (US 4,308,368) 72,000 MW 48% $NCH_3$; 52% NH
j - PG 2 "POG-318" 100,000 MW 100% NH
k - PG 3 12,000 MW 100% NH
l - XP0103 Shipley Novolak Resin 12000 MW
m - XP1119 Shipley Novolak Resin 8000 MW
n - S-1350H Shipley Microposit Photoresist 1350H
o - Monazoline C 1-alkyl-2-hydroxyethyl imidazoline
p - all positive flood exposures are $1J/cm^2$

The terms "Monazoline", "Bisphenol", "Cymel", "Beetle", "Proposal", "Cellosolve", "Kodak", "Waycoat", "Microposit" and "Abitol" are trade marks, which may or may not be registered in some or all of the designated states.

## Claims

1. A process for forming a thermally stable, positive or negative image on a substrate surface characterized in that it comprises:
   a) preparing a photosensitive coating composition comprising aminoplast resin and reactive hydrogen containing compound, or phenoplast resin and latent formaldehyde generating compound, as acid hardening resin system, and naphthoquinone diazide sulfonic acid ester or polymer derived therefrom as photoacid generator, dissolved in suitable solvent;
   b) depositing the coating composition on a substrate surface;
   c) drying the coated substrate surface to form a touch tack free photosensitive film on the substrate surface;
   d) creating an acidic latent image in the film by exposing the film to a source of actinic radiation; and
   e) either
      i) forming a negative image on the substrate surface by heating the acidic latent image in the film to 70 to 120 °C, re-exposing the film to a source of actinic radiation, and developing the re-exposed film with an aqueous solution; or
      ii) forming a positive image on the substrate surface by removing the acidic latent image in the film with an aqueous solution and leaving a remaining film on the substrate surface, re-exposing the remaining film to a source of actinic radiation to form a second acidic latent image in the remaining film, and heating the second acidic latent image in the remaining film to 70 to 120 °C.

2. A process as claimed in claim 1, wherein the aminoplast resin comprises one or more of melamine-, benzoguanamine-, and urea-formaldehyde resins.

3. A process as claimed in claim 1 or claim 2, wherein the reactive hydrogen containing compound comprises alkali soluble resin, the alkali soluble resin being one or more of phenolic novolaks, cresolic novolaks, polyglutarimides, polyvinylphenols, and (meth)acrylic acid-styrene copolymers formed from at least 15 weight percent (meth)acrylic acid.

4. A process as claimed in claim 1, wherein the acid hardening resin system comprises novolak resin and latent formaldehyde generating compound.

5. A process as claimed in claim 4, wherein the latent formaldehyde generating compound comprises 2-hydroxyethyloxazolidine and/or oxazolidinylethyl methacrylate.

6. A process as claimed in any of claims 1 to 3, wherein the photosensitive coating composition comprises 3 to 50 parts by weight of said aminoplast resin, 90 to 40 parts by weight of said reactive hydrogen containing compound and 2 to 30 parts by weight of said photoacid generator.

7. A process as claimed in claim 1, wherein said acid hardening resin system comprises phenoplast resin and formaldehyde generating compound, and wherein, in said photosensitive coating composition, said phenoplast resin is present in an amount of 50 to 95 parts by weight, said formaldehyde generating compound is present in an amount of 40 to 3 parts by weight, and said photoacid generator is present in an amount of 2 to 30 parts by weight.

8. A process as claimed in any of claims 1 to 5, wherein the photosensitive coating composition comprises 20 to 30 weight percent of said photoacid generator and 80 to 75 weight percent of said add hardening resin system, based on the total solids content of said composition.

9. A process as claimed in claim 1, wherein the coating composition is in the form of a photoresist comprising novolak resin and naphthoquinone diazide photoacid generator dissolved in a suitable solvent, there being incorporated therein 5 to 50 parts by weight of acid hardening aminoplast or formaldehyde generating compound, based on 100 parts by weight of the novolak resin.

10. A process as claimed in any of claims 1 to 9, wherein the image has a resolution of about 0.7 micrometers.

11. A process for forming a thermally stable positive or negative planarizing layer image on a substrate surface comprising forming a positive or a negative image on a substrate surface by a process as

claimed in any of claims 1 to 10, employing the imaged surface formed thereby and repeating the process as claimed in any of claims 1 to 10 on said imaged surface.

**Revendications**

1. Un procédé de formation d'une image positive ou négative stable à la chaleur sur une surface de substrat, caractérisé en ce qu'il consiste
   a) à préparer une composition de revêtement photosensible comprenant, en tant que système de résine durcissant à l'acide, une résine aminoplaste et un composé à hydrogène actif ou une résine phénoplaste et un composé générateur de formaldéhyde latent et un ester d'acide naphtoquinone diazide sulfonique ou un polymère en dérivant en tant que générateur photoacide, dissoute dans un solvant approprié :
   b) à déposer la composition de revêtement sur une surface de substrat ;
   c) à sécher la surface de substrat revêtue pour former sur la surface du substrat un film photosensible sec au toucher ;
   d) à créer une image latente acide dans le film en exposant le film à une source de rayonnement actinique et
   e) soit
      i) à former une image négative sur la surface du substrat par chauffage de l'image latente acide dans le film entre 70 et 120°C, à réexposer le film à une source de rayonnement actinique et a développer le film exposé avec une solution aqueuse ; soit
      ii) à former une image positive sur la surface du substrat en éliminant l'image latente acide dans le film avec une solution aqueuse et en laissant un film résiduel sur la surface du substrat, à réexposer le film résiduel à une source de rayonnement actinique en vue de former une seconde image latente acide dans le film résiduel et à chauffer la seconde image latente acide dans le film résiduel entre 70 et 120°C.

2. Procédé selon la revendication 1, dans lequel la résine aminoplaste comprend une ou plusieurs résines de mélamine-, de benzoguanamine- et d'urée-formaldéhyde.

3. Un procédé selon la revendication 1 ou 2, dans lequel le composé à hydrogène actif comprend une résine soluble dans les alcalis, la résine soluble dans les alcalis étant un ou plusieurs des novolaques phénoliques, novolaques crésoliques, polyglutarimides, polyvinylphénols et copolymères d'acide (méth)acrylique-styrène formés à partir d'au moins 15 pourcent en poids d'acide (méth)acrylique.

4. Procédé selon la revendication 1, dans lequel le système durcissant à l'acide comprend une résine novolaque et un composé générateur de formaldéhyde latent.

5. Procédé selon la revendication 4, dans lequel le composé générateur de formadéhyde latent comprend la 2-hydroxyéthyloxazolidine et/ou le méthacrylate d'oxazolidinyléthyle.

6. Procédé selon l'une des revendications 1 à 3, dans lequel la composition de revêtement photosensible contient 3 à 50 parties en poids de ladite résine aminoplaste, 90 à 40 parties en poids dudit composé à hydrogène actif et 2 à 30 parties en poids dudit générateur photoacide.

7. Procédé selon la revendication 1, dans lequel ledit système de résine durcissant à l'acide comprend une résine phénoplaste et un composé générateur de formaldéhyde et dans lequel la résine phénoplaste est présente dans ladite composition de revêtement photosensible en une quantité de 50 à 95 parties en poids, le composé générateur de formaldéhyde est présent en une quantité de 40 à 3 parties en poids et le générateur photoacide est présent en une quantité de 2 à 30 parties en poids.

8. Procédé selon l'une des revendications 1 à 5, dans lequel la composition de revêtement photosensible contient 20 à 30 pourcent en poids dudit générateur photoacide et 80 à 75 pourcent en poids dudit système de résine durcissant à l'acide, par rapport au taux de solides total de ladite composition.

9. Procédé selon la revendication 1, dans lequel la composition de revêtement se présente sous une forme photorésistante contenant une résine novolaque et un générateur photoacide à base de naphtoquinone diazide dissous dans un solvant approprié, 5 à 50 parties en poids d'aminoplaste

durcissant à l'acide ou d'un composé générateur de formaldéhyde, par rapport à 100 parties en poids de la résine novolaque, étant incorporées dans la composition.

**10.** Procédé selon l'une des revendications 1 à 9, dans lequel l'image possède une résolution d'environ 0,7 micromètre.

**11.** Un procédé de formation d'une image positive ou négative à couche planarisante stable à la chaleur sur une surface de substrat consistant à former une image positive ou négative sur une surface de substrat par un procédé selon l'une des revendications 1 à 10, à utiliser la surface porteuse de l'image ainsi formée et à répéter sur ladite surface porteuse de l'image le procédé selon l'une des revendications 1 à 10.

## Patentansprüche

**1.** Verfahren zum Erzeugen eines thermisch stabilen, positiven oder negativen Bildes auf einer Substratoberfläche,
**dadurch gekennzeichnet,** daß man
a) eine photoempfindliche Beschichtungszusammensetzung herstellt, welche enthält ein Aminoplastharz und eine reaktiven Wasserstoff enthaltende Verbindung oder ein Phenoplastharz und eine latenten Formaldehyd erzeugende Verbindung als sauer härtendes Harzsystem und einen Naphthochinondiazidsulfonsäureester oder ein davon abgeleitetes Polymer als Photosäureerzeuger, gelöst in einem geeigneten Lösemittel;
b) die Beschichtungszusammensetzung auf einer Substratoberfläche abscheidet;
c) die beschichtete Substratoberfläche trocknet zur Bildung eines bei Berührung nicht klebrigen photosensitiven Films auf der Substratoberfläche;
d) ein saures latentes Bild in dem Film erzeugt durch Belichten des Films mit einer Quelle für chemisch wirksame Strahlung; und
e) entweder
i) ein negatives Bild auf der Substratoberfläche erzeugt durch Erwärmen des sauren latenten Bildes in dem Film auf 70 bis 120 °C, den Film mit einer Quelle für chemisch wirksame Strahlung wiederbelichtet und den belichteten Film mit einer wäßrigen Lösung entwickelt; oder
ii) ein positives Bild auf der Substratoberfläche erzeugt durch Entfernen des sauren latenten Bildes in dem Film mit einer wäßrigen Lösung und Belassen eines verbleibenden Films auf der Substratoberfläche, den verbleibenden Film mit einer Quelle für chemisch wirksame Strahlung zur Bildung eines zweiten sauren latenten Bildes im verbleibenden Film wiederbelichtet und das zweite saure latente Bild im verbleibenden Film auf 70 bis 120 °C erwärmt.

**2.** Verfahren nach Anspruch 1, wobei das Aminoplastharz eines oder mehrere aus Melamin-, Benzoguanamin- und Harnstofformaldehydharzen enthält.

**3.** Verfahren nach Anspruch 1 oder 2, wobei die reaktiven Wasserstoff enthaltende Verbindung ein alkalilösliches Harz enthält, wobei das alkalilösliche Harz eines oder mehrere ist aus Phenolnovolaken, Cresolnovolaken, Polyglutarimiden, Polyvinylphenolen und (Meth)Acrylsäure/ Styrol-Copolymeren, die aus mindestens 15 Gew.-% (Meth) Arcrylsäure hergestellt sind.

**4.** Verfahren nach Anspruch 1, wobei das sauer härtende Harzsystem Novolakharz und eine latenten Formaldehyd erzeugende Verbindung enthält.

**5.** Verfahren nach Anspruch 4, wobei die latenten Formaldehyd erzeugende Verbindung 2-Hydroxyethyloxazolidin und/ oder Oxazolidinylethylmethacrylat enthält.

**6.** Verfahren nach einem der Ansprüche 1 bis 3, wobei die photoempfindliche Beschichtungszusammensetzung 3 bis 5 Gew.-% des Aminoplastharzes, 90 bis 40 Gew.-% der reaktiven Wasserstoff enthaltenden Verbindung und 2 bis 30 Gew.-% des Photosäureerzeugers enthält.

**7.** Verfahren nach Anspruch 1, wobei das sauer härtende Harzsystem ein Phenoplastharz und eine Formaldehyd erzeugende Verbindung enthält, und wobei in der photoempfindlichen Beschichtungszusammensetzung das Phenoplastharz anwesend ist in einer Menge von 50 bis 95 Gew.-%, die

Formaldehyd erzeugende Verbindung anwesend ist in einer Menge von 40 bis 3 Gew.-%, und der Photosäureerzeuger anwesend ist in einer Menge von 2 bis 30 Gew.-%.

8. Verfahren nach einem der Ansprüche 1 bis 5, wobei die photoempfindliche Beschichtungszusammensetzung 20 bis 30 Gew.-% des Photosäureerzeugers und 80 bis 75 Gew.-% des sauer härtenden Harzsystems enthält, bezogen auf den Gesamtfeststoffgehalt der Zusammensetzung.

9. Verfahren nach Anspruch 1, wobei die Beschichtungszusammensetzung in Form eines Photoresists vorliegt, die Novolakharz und einen Naphthochinondiazid-Photosäureerzeuger enthält, der in einem geeigneten Lösemittel gelöst ist, wobei darin 5 bis 50 Gewichsteile, bezogen auf 100 Gewichtsteile des Novolakharzes, eines sauer härtenden Aminoplasts oder einer Formaldehyd erzeugenden Verbindung eingebaut sind.

10. Verfahren nach einem der Ansprüche 1 bis 9, wobei das Bild eine Auflösung von etwa 0,7 Mikrometer hat.

11. Verfahren zum Bilden eines thermisch stabilen positiven oder negativen einebnenden Schichtbildes auf einer Substratoberfläche; wobei man mit einem Verfahren nach einem der Ansprüche 1 bis 10 auf einer Subtratoberfläche ein positives oder negatives Bild erzeugt und wobei man unter Einsatz der dadurch mit einem Bild versehenen Oberfläche das Verfahren gemäß einem der Ansprüche 1 bis 10 auf der mit dem Bild versehenen Oberfläche wiederholt.

FIG. I

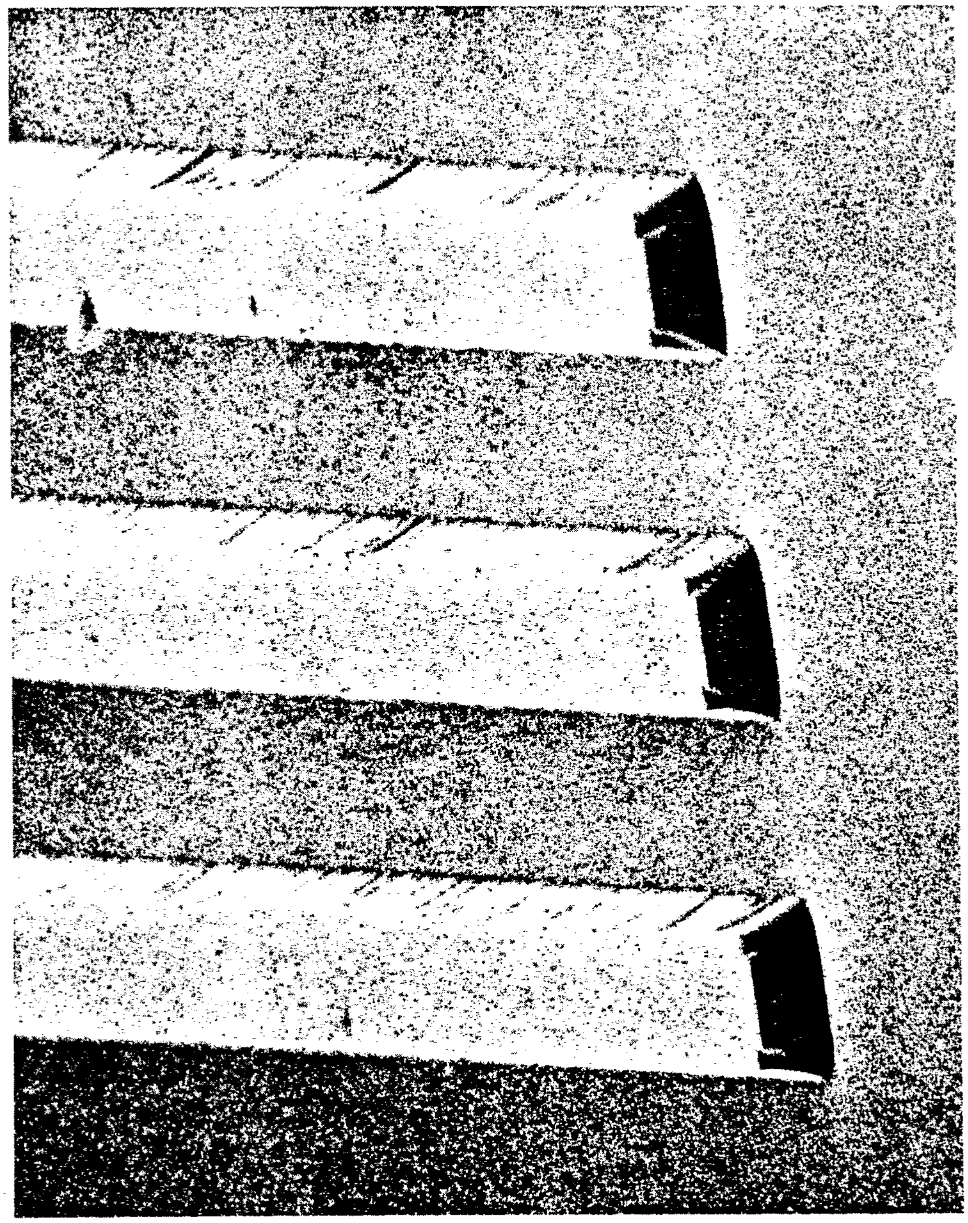

FIG.2

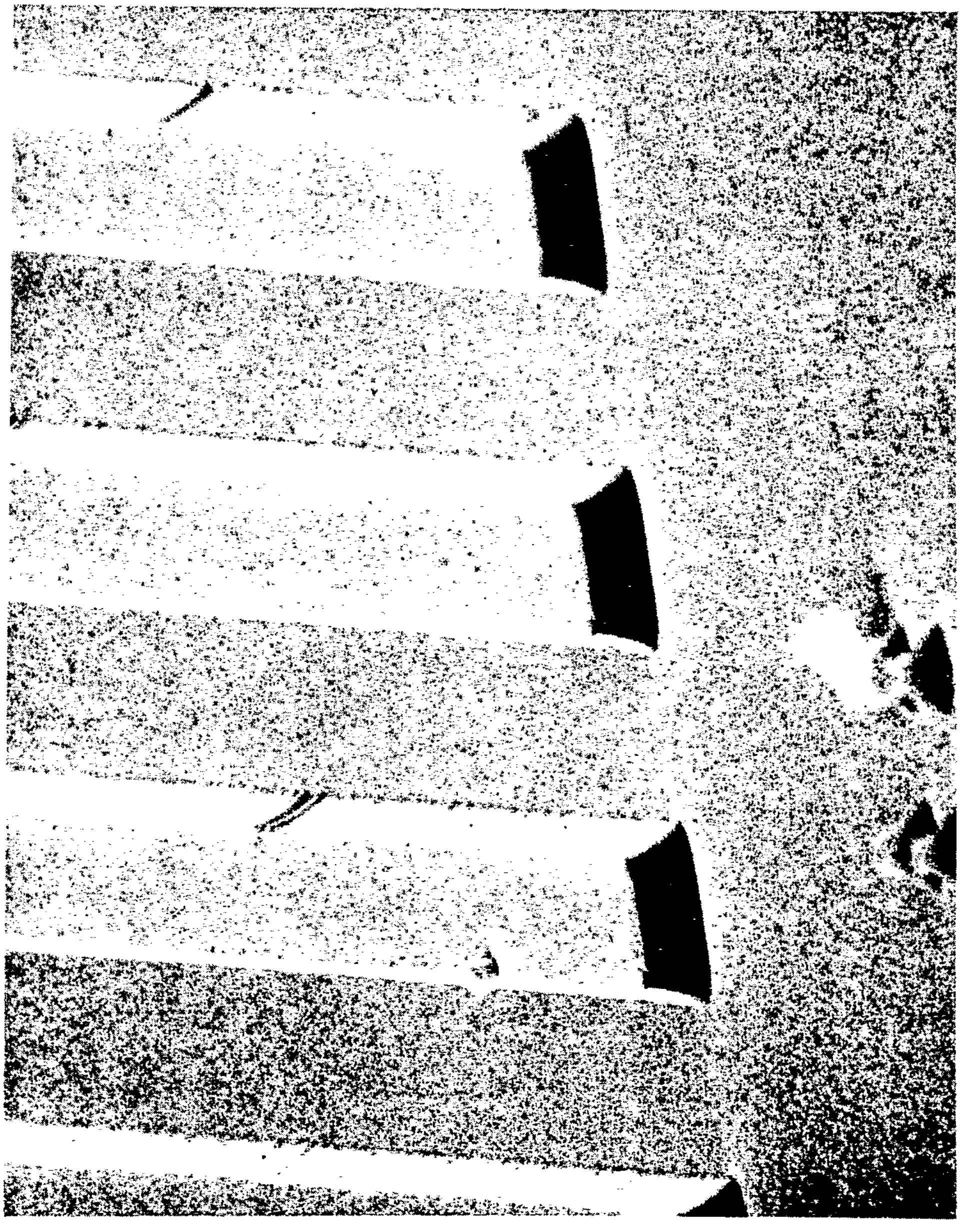

FIG.3

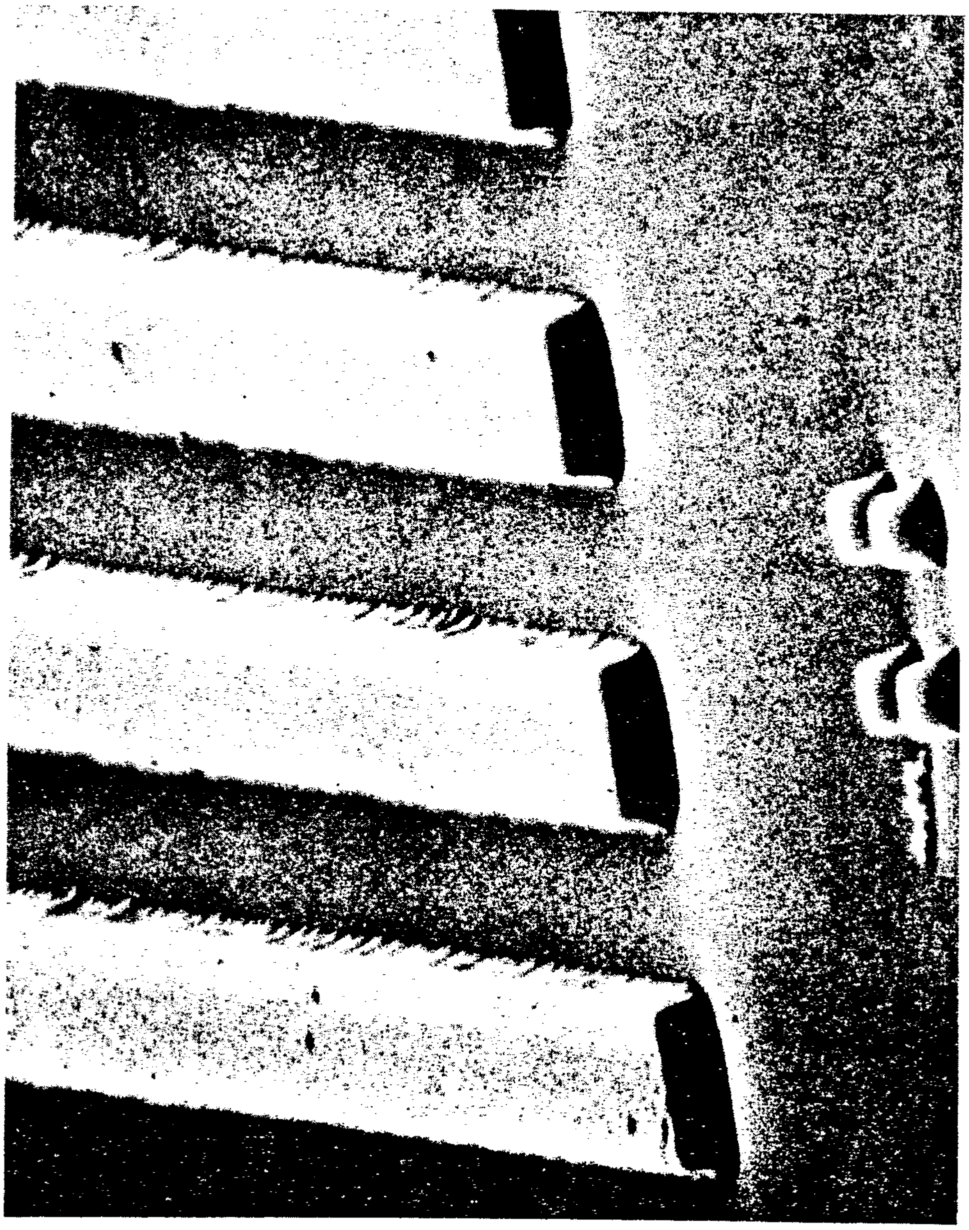

FIG. 4

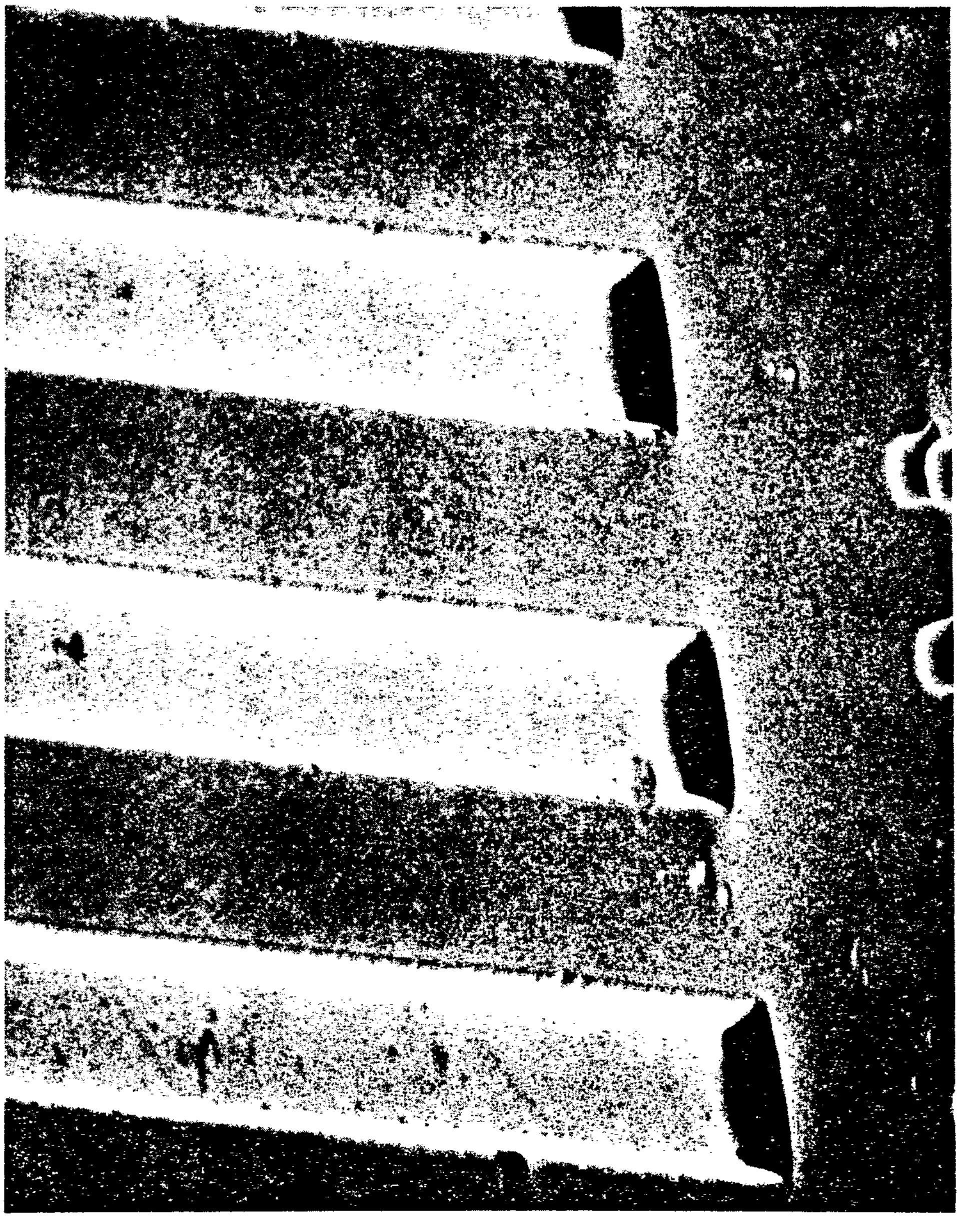

FIG. 5

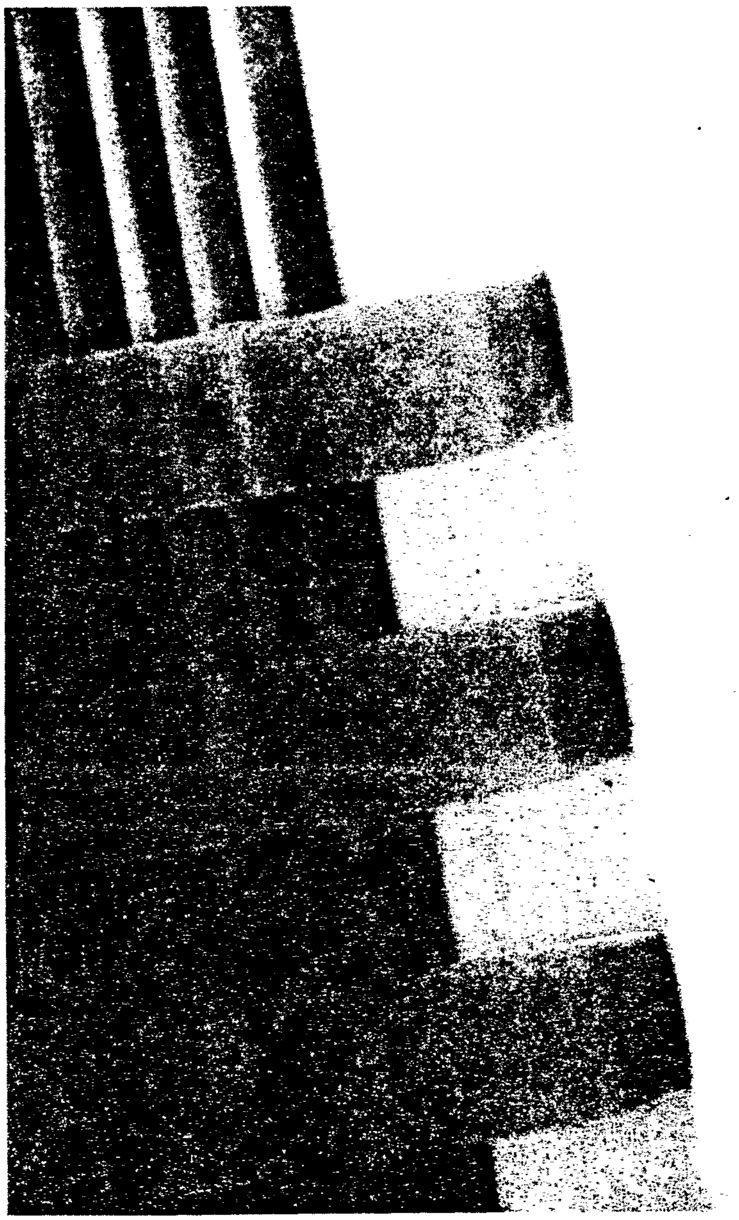

FIG.6

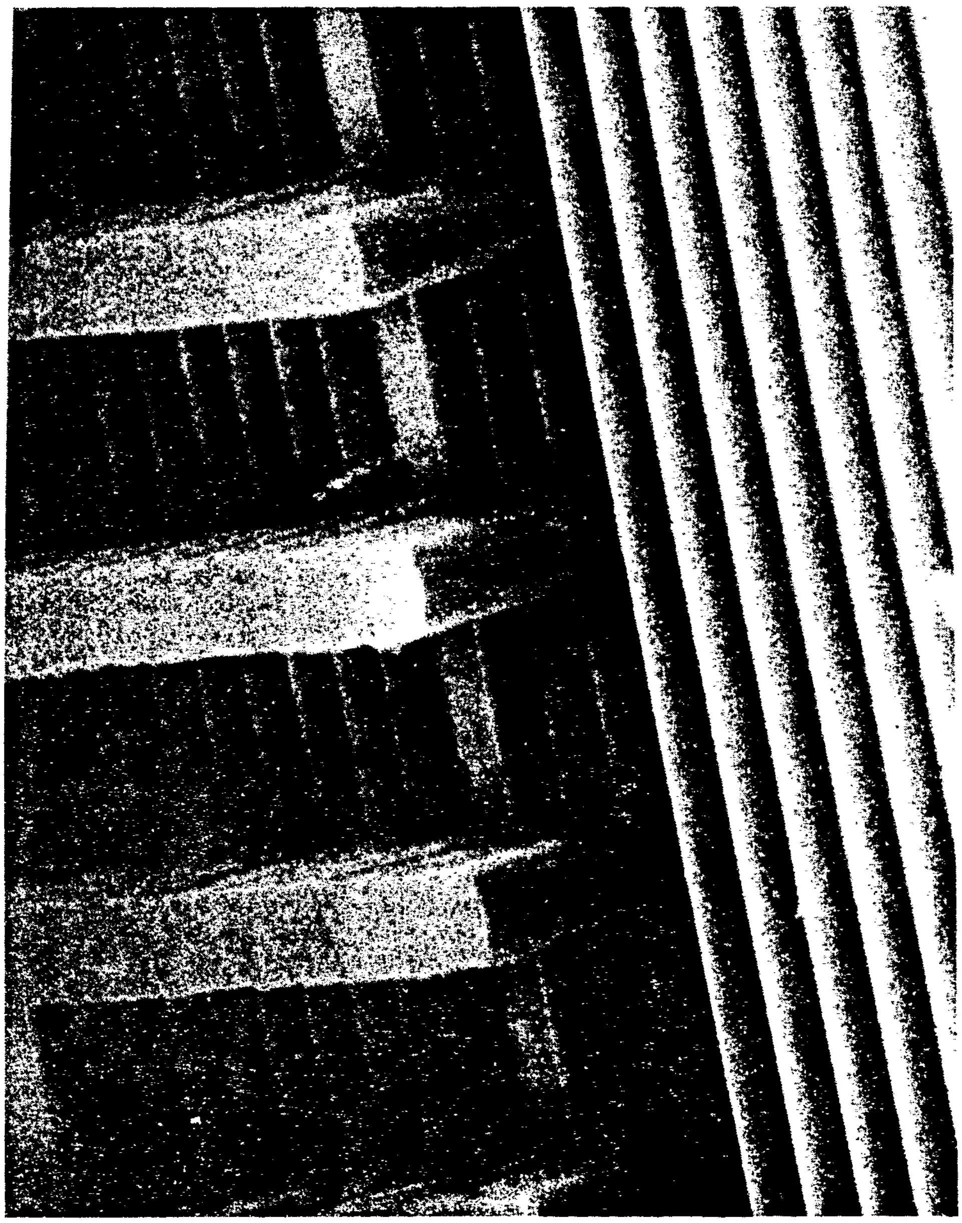

FIG.7

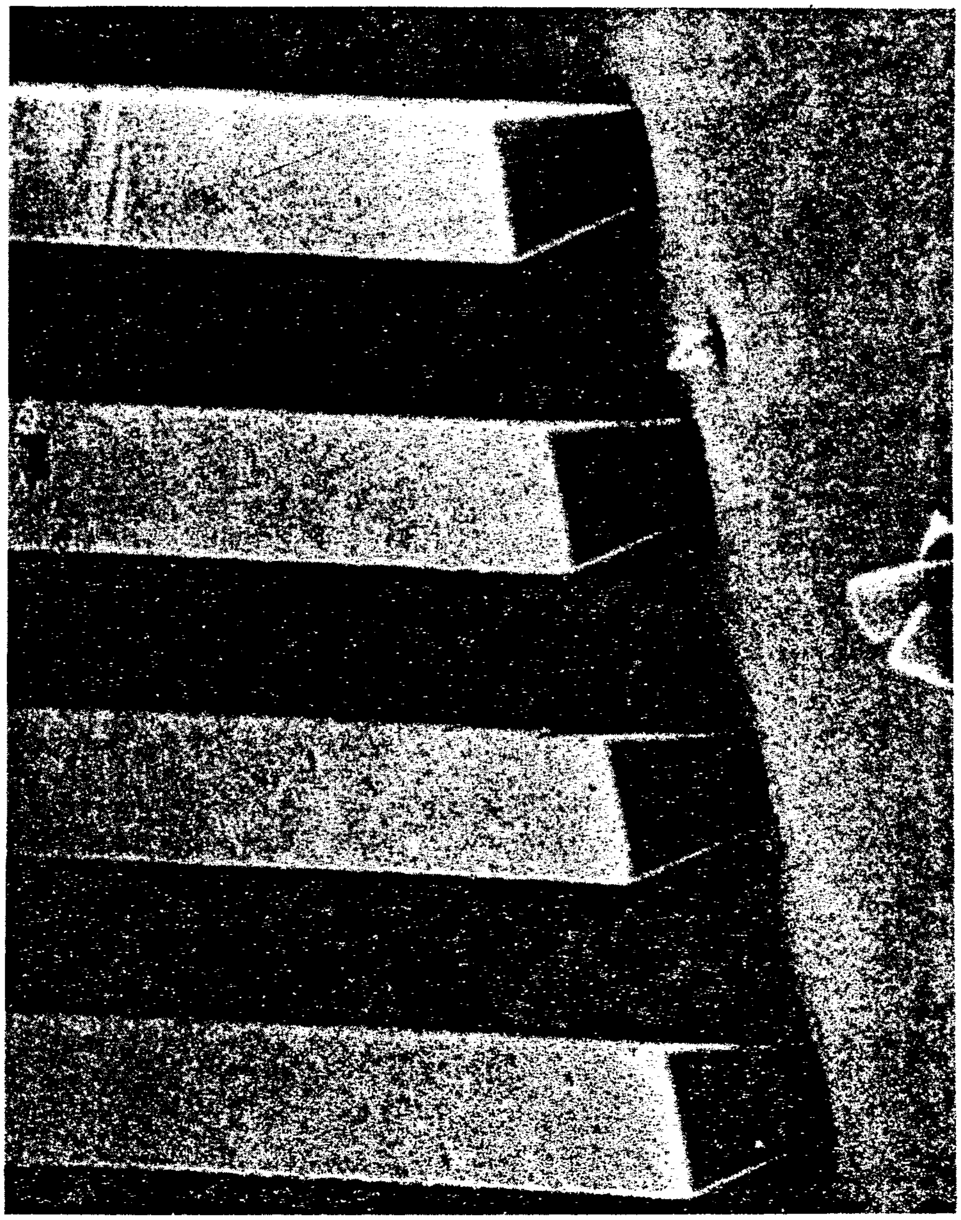

FIG.8